(19) Europäisches Patentamt / European Patent Office / Office européen des brevets

(11) **EP 4 020 525 A1**

(12) **DEMANDE DE BREVET EUROPEEN**

(43) Date de publication:
**29.06.2022  Bulletin 2022/26**

(21) Numéro de dépôt: **21216193.9**

(22) Date de dépôt: **21.12.2021**

(51) Classification Internationale des Brevets (IPC):
***H01L 21/02*** *(2006.01)*

(52) Classification Coopérative des Brevets (CPC):
**H01L 21/02381; H01L 21/0245; H01L 21/02458;
H01L 21/02505; H01L 21/0254; H01L 21/02639;
H01L 21/0265;** H01L 33/007; H01L 33/0093

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **22.12.2020  FR 2013963**

(71) Demandeurs:
• **Commissariat à l'Energie Atomique et aux Energies Alternatives
75015 Paris (FR)**

• **Centre national de la recherche scientifique
75016 Paris (FR)**
• **Université Grenoble Alpes
38400 Saint-Martin-d'Hères (FR)**

(72) Inventeurs:
• **CHARLES, Matthew
38054 GRENOBLE Cedex 09 (FR)**
• **FEUILLET, Guy
38054 GRENOBLE Cedex 09 (FR)**
• **DAGHER, Roy
06200 NICE (FR)**

(74) Mandataire: **Hautier, Nicolas
Cabinet Hautier
20, rue de la Liberté
06000 Nice (FR)**

(54) **PROCÉDÉ DE RÉALISATION D'UNE COUCHE DE NITRURE**

(57)  L'invention concerne notamment un procédé d'obtention d'au moins une couche (550) de nitrure, le procédé comprenant les étapes successives suivantes :
- fournir un empilement comprenant une pluralité de plots (1000A1-1000B4) s'étendant depuis un substrat (100) de l'empilement, chaque plot (1000A1-1000B4) comprenant au moins:
• un tronçon cristallin (300A1, 300B4),
• un sommet (1010), présentant une surface sommitale,

- faire croître par épitaxie une cristallite (510A1-510B4) depuis le sommet (1010) de certains au moins desdits plots (1000A1-1000B4) de l'ensemble (1000A, 1000B) et poursuivre la croissance épitaxiale des cristallites (510A1-510B4) jusqu'à coalescence des cristallites (510A1-510B4) portées par les plots (1000A1-1000B4)
- la pluralité de plots (1000A1-1000B4) comprend au moins un plot (1001), dit de rétention, et plusieurs autres plots (1002), dit de séparation,

Les plots sont configurés de sorte qu'une fois la couche (550) de nitrure formée l'au moins un plot de rétention (1001) retient la couche (550) de nitrure et certains des plots de séparation (1002) peuvent se fracturer

FIG. 5A

EP 4 020 525 A1

## Description

L'invention concerne la réalisation d'une couche de nitrure (N) obtenue de préférence à partir d'au moins l'un parmi le gallium (Ga), l'indium (In) et l'aluminium (Al). L'invention trouve par exemple pour application le domaine des dispositifs optoélectroniques comprenant une pluralité de diodes électroluminescentes (LED) de taille micrométrique, généralement appelées micro-LEDs ou encore la réalisation de composants de puissance tels que des transistors ou des diodes de puissance.

## ETAT DE LA TECHNIQUE

Pour de nombreuses applications micro-électroniques ou optoélectroniques, on souhaite réaliser des couches de nitrure à partir d'au moins l'un parmi le gallium, l'indium et l'aluminium. Des applications spécifiques concernent par exemple la réalisation de micro-LEDs. D'autres applications spécifiques peuvent concerner la réalisation de dispositifs électroniques de puissance tels que des diodes ou des transistors de puissance, par exemple des transistors HEMT (acronyme de leur appellation anglosaxonne «High Electron Mobility Transistor» signifiant transistor à effet de champ à haute mobilité d'électrons).

Une couche de nitrure est classiquement obtenue par croissance épitaxiale à partir d'une couche cristalline recouvrant une plaque.

Un enjeu majeur consiste à minimiser la densité de défauts dans la couche de nitrure obtenue par épitaxie. En effet, les performances des dispositifs micro-électroniques ou optoélectroniques réalisés à partir de ces couches de nitrure sont très sensibles à la densité de défauts de structure tels que les dislocations.

Ces dislocations ont pour origine la différence de paramètre de maille entre la couche épitaxiée et le substrat, ainsi que la coalescence des grains de faible dimension qui sont formés au début de la croissance ; ces grains sont légèrement désorientés les uns par rapport aux autres et ils se joignent en formant au niveau du joint de coalescence, des dislocations qui traversent ensuite toute la structure épitaxiée.

La façon la plus directe pour résoudre ces problèmes consiste à utiliser des substrats de même nature que les couches que l'on veut épitaxier (homo-substrats). Cependant, ces substrats ne sont pas disponibles commercialement ou ne sont encore que de faibles dimensions, ce qui ne permet pas d'y découper des substrats de dimensions suffisantes pour les applications industrielles envisagées.

Les solutions envisagées à ce jour pour des applications industrielles reposent donc principalement sur l'utilisation d'hétéro-substrats en combinaison avec des méthodes dites de « recroissance latérale » ou ELOG, acronyme de l'anglais «epitaxial lateral overgrowth ». Cette méthode, basée sur l'utilisation d'un masque pour bloquer les dislocations, permet de réduire la densité de ces dernières. En revanche, ces dislocations sont distribuées de façon non uniforme, ce qui peut poser problème lors de la fabrication des dispositifs.

Une autre solution consiste à faire recroitre par épitaxie du matériau sur des plots préexistants de ce matériau : il s'agit du procédé dit de pendeo-épitaxie qui permet de s'affranchir de la recroissance sur le masque. En revanche, les solutions classiques de pendeo-épitaxie ne permettent pas d'éliminer, voire de réduire significativement, l'apparition de défauts générés par la coalescence de germes adjacents.

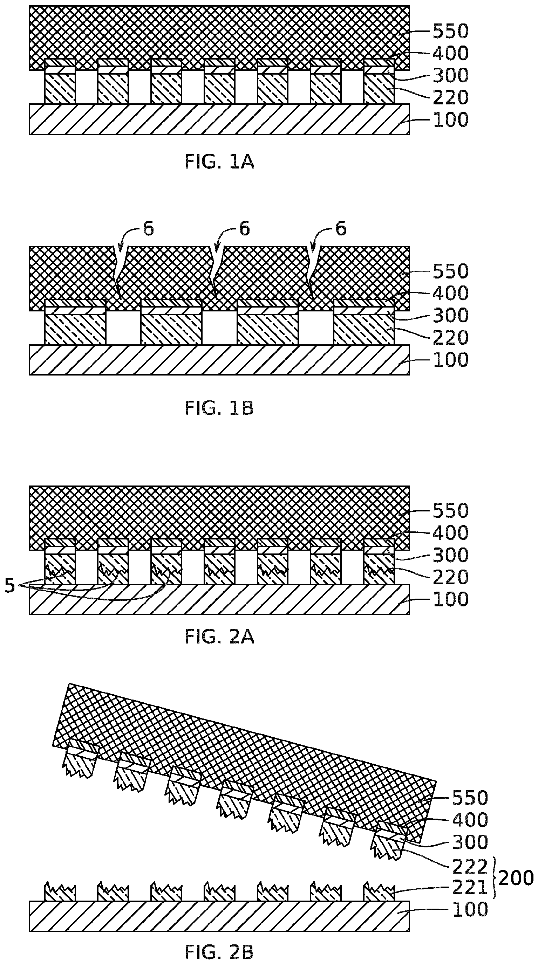

La demande de brevet WO2019122461, décrit une solution qui consiste à faire croître une couche de nitrure sur des plots, également désignés piliers, comprenant un tronçon de fluage surmonté d'un tronçon cristallin. La structure obtenue en mettant en œuvre ce procédé est illustré en figure 1A. Des plots comprenant un tronçon de fluage 220, un tronçon cristallin 300 et une couche tampon 400 sont formés à la surface d'un substrat 100. On fait ensuite croître par épitaxie des cristallites à la surface des plots 1000. Les cristallites se rejoignent lors de la coalescence, puis forment une couche 550 de nitrure qui poursuit sa croissance en s'épaississant.

Cette solution présente pour inconvénient que lors du refroidissement de la couche de nitrure 550, cette dernière peut parfois présenter des fissures 6 importantes qui traversent son épaisseur. Cet inconvénient est illustré en figure 1B. La couche de nitrure ainsi obtenue n'est alors plus utilisable. Cet inconvénient se manifeste d'autant plus que la couche de nitrure 550 est épaisse.

Il existe donc un besoin consistant à proposer une solution pour réduire, voire pour supprimer, au moins certains des inconvénients que présentent les solutions connues.

Un objectif de la présente invention sera alors de proposer une solution pour obtenir une couche de nitrure (N) obtenue à partir d'au moins l'un parmi le gallium (Ga), l'indium (In) et l'aluminium (Al), présentant une densité de défauts significativement réduite et non fissurée.

Les autres objets, caractéristiques et avantages de la présente invention apparaîtront à l'examen de la description suivante et des dessins d'accompagnement. Il est entendu que d'autres avantages peuvent être incorporés.

## RESUME

Pour atteindre cet objectif, selon un mode de réalisation on prévoit on prévoit un procédé d'obtention d'au moins une couche, dite de nitrure, faite au moins en partie d'un nitrure (N) d'au moins l'un parmi le gallium (Ga), l'indium (In) et l'aluminium (Al).

Le procédé comprend les étapes successives suivantes:

- fournir un empilement comprenant une pluralité de plots s'étendant depuis un substrat de l'empilement, les plots étant répartis sur le substrat de manière à former au moins un ensemble de plots, chaque plot comprenant au moins :

- un tronçon cristallin,
- un sommet, présentant une surface sommitale, destinée à former une couche de germination pour une étape d'épitaxie subséquente,

- faire croître par épitaxie une cristallite depuis le sommet de certains au moins desdits plots de l'ensemble et poursuivre la croissance épitaxiale des cristallites jusqu'à coalescence des cristallites portées par les plots adjacents de l'ensemble, de manière à former sur l'ensemble de plots, ladite couche de nitrure.

Pour chaque ensemble, la pluralité de plots comprend au moins un plot, dit de rétention, et plusieurs autres plots, dits de séparation.

L'au moins un plot de rétention diffère des plots de séparation par au moins un paramètre pris parmi :

- une surface sommitale $S_{plotR}$ de l'au moins un plot de rétention, avec $S_{plotR} \geq 1,2 * S_{plots}$, $S_{plotS}$ étant une surface sommitale des plots de séparation,
- les matériaux constituant l'au moins un plot de rétention et les plots de séparation, les plots de séparation comprenant un tronçon de fluage, formé en un matériau amorphe présentant une température de transition vitreuse Ttransition vitreuse, le tronçon cristallin surmontant le tronçon de fluage, les plots de rétention

  - ne présentant pas de tronçon de fluage ou
  - présentant un tronçon de fluage moins épais que le tronçon de fluage des plots de séparation, ou
  - présentant un tronçon de fluage présentant une température de transition vitreuse $T_{transition}$ vitreuse supérieure, de préférence d'au moins 1,2 fois, à la température de transition vitreuse Ttransition vitreuse du tronçon de fluage des plots de séparation,

- une distance $D_R$, $D_R$ étant la distance séparant l'au moins un plot de rétention d'autres plots de rétention qui lui sont adjacents et qui appartiennent à l'ensemble de plots, avec $D_R *1,2 \leq D_s$, $D_s$ étant la distance séparant les plots de séparation adjacents appartenant à l'ensemble de plots.

Ainsi, le procédé proposé prévoit de faire varier les propriétés des plots d'un ensemble de plots destinés à soutenir une couche. Certains plots (les plots de séparation) sont destinés à se rompre, d'eux-mêmes ou facilement sous l'action d'une contrainte mécanique ou thermique par exemple. D'autres plots (les plots de rétention), sont configurés pour ne pas se rompre sous l'effet de cette contrainte. Ainsi, les différentiels de dilatation, imposés par les différents coefficients d'expansion thermique (CTE) que présentent les matériaux de la structure, en particulier entre le nitrure et le matériau de la couche cristalline (par exemple du silicium), sont absorbés par les plots de séparation, qui constituent des zones de fragilité. Ces plots de séparation peuvent ainsi rompre sous l'effet de la différence des CTE.

On évite ainsi que les contraintes générées par les différentiels de CTE, notamment lors de la phase de refroidissement en fin d'épitaxie, se concentrent dans la couche de nitrure pour y induire des fissures comme illustré en figure 1B. Le procédé proposé permet ainsi d'éviter l'apparition de fissures. Cet avantage est particulièrement important lorsque l'on souhaite réaliser des couches de nitrure épaisses, puisque plus la couche de nitrure est épaisse, plus elle sera sujette aux effets de fissuration liées aux dilatations thermiques. Le procédé proposé trouve donc comme application particulièrement avantageuse la réalisation de dispositifs électroniques de puissance avec de hautes densités de courant et de hautes tensions (tels que des diodes de puissance ou des transistors de puissance de type HEMTs par exemple), puisque dans ces dispositif les couches de nitrure sont épaisses. Le procédé proposé apporte donc une solution pratiquement efficace à sa problématique consistant à obtenir des couches de nitrure, par exemple de GaN, présentant une épaisseur d'au moins 1 $\mu$m voire d'au moins 5 $\mu$m ($10^{-6}$ mètres) allant jusqu'à 10 $\mu$m voire plus sans manifestation de fissures.

Par ailleurs, le procédé proposé procure les avantages de la méthode décrite dans le document WO2019122461, en termes de réduction, voire de suppression, des dislocations au niveau des joints de coalescence entre deux cristallites. Ainsi, le procédé proposé permet d'obtenir dans une couche, même épaisse, des densités de dislocation faibles, dans certains cas aussi faibles que $1 \times 10^6 cm^{-2}$, ce qui est très inférieur aux densités de dislocation obtenues avec les solutions classiques de croissance de GaN sur silicium (Si) ou sur carbure de silicium (SiC) ou sur saphir ( typiquement $1 \times 10^8$ à $1 \times 10^9 cm^{-2}$))

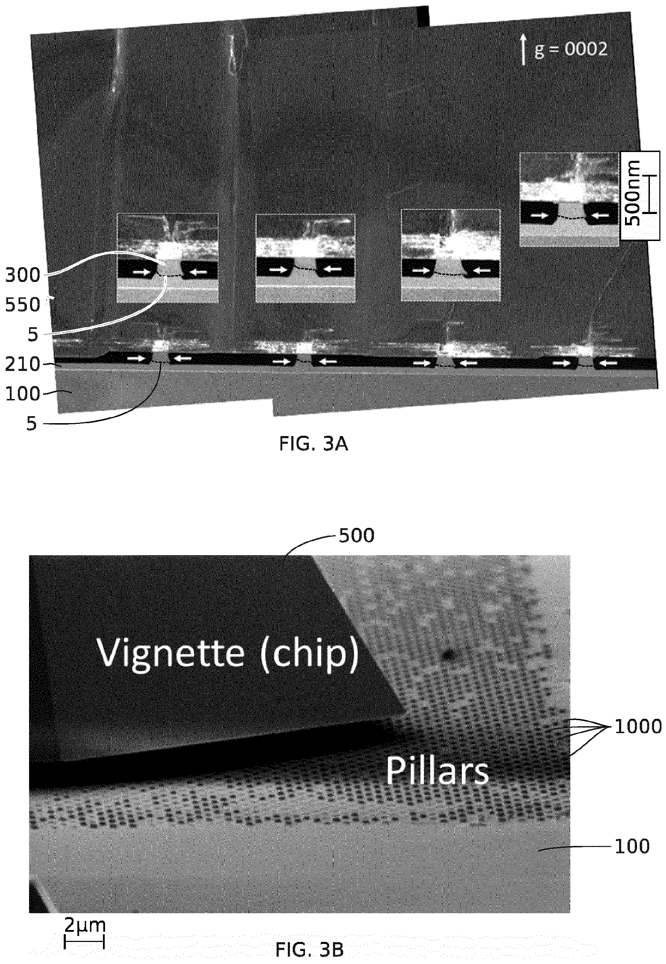

La figure 3A est une photographie de microscopie électronique en transmission illustrant la fracturation des plots. Sur cette photographie, prise selon une coupe perpendiculaire à la face du substrat supportant les plots, on identifie clairement la fracture au niveau de chacun des tronçons de fluage.

La figure 3B est une photo illustrant une couche, formant ici une vignette, qui s'est entièrement désolidarisée du substrat. Chacun des plots soutenant la vignette s'est fracturé. Il n'est alors plus possible de contrôler avec précision la position de cette vignette. Les techniques classiques de pick and place (prélèvement et dépôt) ne peuvent alors pas être mises en œuvre de manière fiable précise. En effet, la séparation des nombreuses vignettes depuis un substrat semble relativement aléatoire et n'est en tout état de cause pas maîtrisée.

Ainsi, le procédé proposé permet d'obtenir une couche de nitrure sans fissures, sans, ou avec très peu de dislocations au niveau des joints de grains, et tout en évitant que la couche se désolidarise de façon non contrôlée par rapport au substrat, voire s'en échappe.

En outre, la séparation créée, initiée ou rendue plus facile au niveau des plots de séparation facilite le démontage de la couche par rapport au substrat.

En résumé, le procédé proposé permet d'éviter les risques de fissuration de la couche de nitrure obtenue, risques d'autant plus importants que la couche de nitrure est épaisse et les plots sont épais. Cet avantage du procédé proposé est alors particulièrement précieux pour la réalisation de dispositifs qui nécessitent des couches de nitrure épaisses tels que les dispositifs de puissance (diodes ou transistors de puissance par exemple).

Plusieurs applications tirent profit de cet avantage en termes de maîtrise de la position des couches de nitrure. Une première application particulièrement avantageuse concerne la réalisation de dispositifs à base de micro LEDs ($\mu$-LEDs). Pour cette application il est avantageux de réaliser un très grand nombre de vignettes sur une même plaque puis de reporter ces vignettes à d'autres emplacements, typiquement par une technique de pick and place.

Une autre application concerne l'électronique de puissance. Pour cette application, dans laquelle les dispositifs sont réalisés verticalement, il est nécessaire d'avoir un bon contact thermique et électrique entre le substrat et la couche de nitrure épitaxiée, typiquement une couche de GaN. Cette condition n'est pas satisfaite pour les couches de GaN sur des plots en $SiO_2$, car ces plots introduisent une couche composée de $SiO_2$ et d'air, qui ont tous deux une très faible conductivité électrique et thermique. Il est donc nécessaire de retirer les puces de GaN de leur substrat de silicium d'origine, de retirer ces couches non conductrices, puis de rattacher les puces à un autre substrat afin de pouvoir fabriquer des dispositifs verticaux pour l'électronique de puissance. L'utilisation de plots de rétention, tel que le prévoit le procédé proposé, garantit que toutes les puces restent correctement positionnées après la croissance, afin qu'elles puissent être retirées avec succès du substrat de silicium, puis refaçonnées en composants alignés. Cela permet une compatibilité avec des plaques de 200 mm ou même de 300 mm de diamètre, garantissant une production de dispositifs avec un faible coût et un contrôle précis.

Le procédé proposé peut en outre présenter au moins l'une des caractéristiques optionnelles suivantes : Selon un exemple, l'au moins un plot de rétention et les plots de séparation sont configurés de sorte qu'une fois la couche de nitrure formée l'au moins un plot de rétention retient la couche de nitrure. De préférence l'au moins un plot de rétention retient la couche de nitrure après un refroidissement de la couche de nitrure jusqu'à la température ambiante.

Selon un exemple, l'au moins un plot de rétention et les plots de séparation sont configurés de sorte qu'une fois la couche de nitrure formée et après un refroidissement de la couche de nitrure à une température au moins deux fois inférieure à une température $T_{épitaxie}$ à laquelle est effectuée la croissance épitaxiale, au moins certains des plots de séparation sont fracturés, voire tous les plots de séparation.

Selon un exemple, le substrat présente un seul ensemble de plots et le substrat porte une seule couche ou vignette de grande taille. De préférence, la couche unique s'étend sur sensiblement toute la surface du substrat.

Selon un mode de réalisation alternatif et préféré, les plots sont répartis sur le substrat de manière à former une pluralité d'ensembles de plots et l'étape de croissance par épitaxie est interrompue avant que des cristallites appartenant à deux ensembles distincts n'entrent en coalescence, de sorte à ce que la couche formée sur chaque ensemble forme une vignette. Les vignettes sont distantes les unes des autres.

Ainsi, ce mode de réalisation non limitatif prévoit la réalisation de multiples vignettes de nitrure (GaN par exemple) à partir d'ensembles de plots gravés dans un empilement comprenant une couche cristalline destinée à l'épitaxie du nitrure et une couche de fluage. Au cours de leur croissance épitaxiale, les cristallites formées au sommet des plots d'un même ensemble de plots se rejoignent pour former une vignette, chacune des vignettes étant destinée à former un dispositif optoélectronique tel qu'une micro-LED par exemple ou un dispositif électronique tel qu'un transistor de puissance, par exemple de type HEMT, ou une diode de puissance. Ces composants pourraient être soit d'architecture latérale, soit d'architecture verticale.

Ce mode de réalisation non limitatif propose une solution clairement opposée à toutes les solutions de l'état de la technique connues et qui prévoient de délimiter par gravure des vignettes à partir d'une couche commune initiale obtenue par épitaxie. Ce mode de réalisation permet de se passer totalement d'une étape de gravure pour délimiter les vignettes. Or, cette étape de gravure s'avère très pénalisante pour l'efficacité de dispositifs tels que les micro-LEDs. Par ailleurs, les solutions développées pour atténuer, sans les éliminer, les inconvénients de cette gravure complexifient considérablement les procédés et induisent d'autres inconvénients. Ce mode de réalisation repose ainsi sur un procédé simple et aisément reproductible, qui permet d'obtenir des vignettes qui n'ont pas été altérées par des procédés de gravures et qui ne présentent pas ou très peu de défauts liés aux joints de coalescence. Ce mode de réalisation permet ainsi d'augmenter considérablement l'efficacité des dispositifs obtenus à partir de ces vignettes. Ce mode de réalisation peut être qualifié de bottom-up puisqu'il permet de réaliser des composants depuis une face inférieure vers une face supérieure, alors qu'habituellement les composants sont réalisés selon les procédés qualifiés de top-down, puisqu'ils consistent à réaliser des composants depuis une face supérieure à une face inférieure.

Dans le cas des micro-LEDs, cette solution permet d'améliorer la brillance des écrans haute résolution réalisés à partir de ces micro-LEDs. En effet, elle permet d'obtenir des micro-LEDs de tailles très petites et présentant une efficacité radiative qui n'a pas été altérée par les effets néfastes causés par la gravure. Les dimensions des vignettes sont déterminées par le réseau de plots. Il est possible de réaliser des vignettes de quelques μm à quelques centaines de μm ($10^{-6}$ mètres) en mettant en œuvre ce procédé.

La précision des procédés mis en œuvre pour réaliser le réseau de plots, déterminera en partie au moins la plus faible dimension possible pour les micro-LED et donc la résolution d'un écran comprenant ces micro-LED. Par exemple, pour des réseaux de plots élaborés par impression nanométrique (nanoimprint) et par lithographie par faisceau d'électron (e-beam), on peut atteindre des tailles de plots de 50 nm et des périodes de 150 à 200 nm. Il est alors possible d'obtenir des tailles de vignettes de 1 à 2 μm. Cela correspond aux tailles de pixels recherchées pour les micro- écrans (souvent désignés μ-display) haute résolution.

Par ailleurs ce procédé permet de réaliser directement des micro-LEDs présentant chacune une taille correspondant à la taille initiale de la vignette, notamment si une hétérostructure à puits quantiques est élaborée sur ces vignettes de nitrure.

Ce mode de réalisation permet également d'obtenir des vignettes que l'on utilise pour la fabrication de dispositifs électroniques de puissance tels que des diodes ou des transistors de type HEMT par exemple. Les vignettes obtenues présentent un taux de dislocations réduit et une meilleure qualité cristalline, les performances électriques des dispositifs de puissance s'en trouvent améliorées.

Un autre aspect de la présente invention concerne un dispositif microélectronique dans lequel chaque couche de nitrure ou chaque vignette forme en partie au moins une diode électroluminescente (LED), une diode de puissance ou un transistor par exemple de type HEMT.

BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1A illustre de manière schématique un empilement selon l'état de la technique, comprenant une couche de nitrure formé sur des plots.
La figure 1B illustre les fissures qui apparaissent dans la couche de nitrure de l'empilement de la figure 1A, lorsque la couche de nitrure refroidit et que la couche de nitrure a été formée sur des plots de forte section.
La figure 2A illustre l'apparition de fractures au sein des plots de l'empilement de la figure 1A, lorsque la couche de nitrure refroidit et que la couche de nitrure a été formée sur des plots de faible section.
La figure 2B illustre l'étape qui suit celle illustrée en figure 2A, avec le détachement involontaire de la couche de nitrure après fracturation de tous les plots.
La figure 3A est une photo obtenue au microscope électronique à transmission (MET) qui illustre l'apparition de fractures au sein des plots.
La figure 3B est une photographie obtenue au microscope électronique à balayage (MEB) qui illustre une vignette involontairement détachée du substrat après fracturation des plots.
Les figures 4A à 4F illustrent des étapes d'un procédé selon un exemple non limitatif du procédé selon la présente invention.

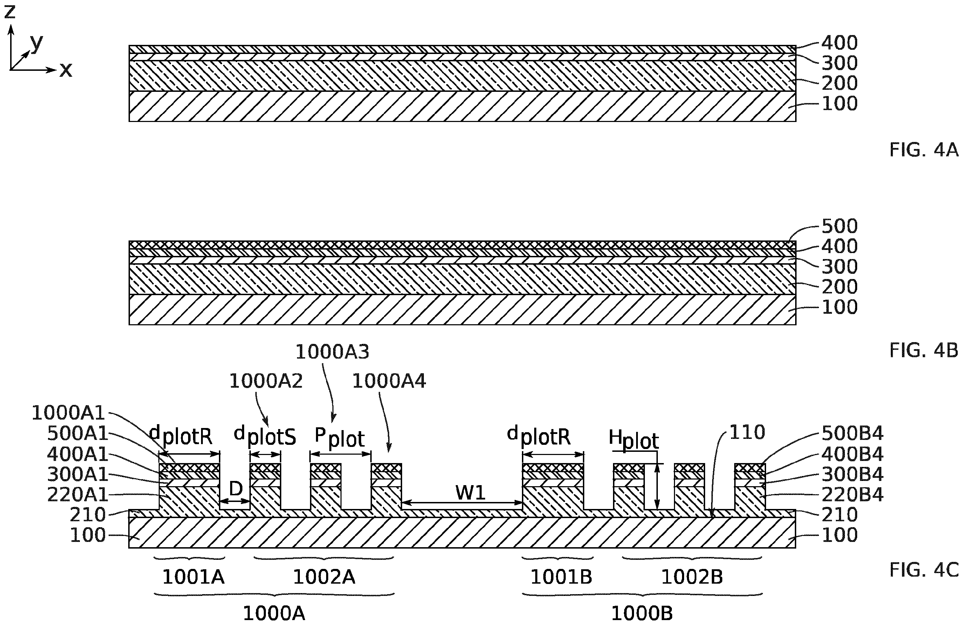

La figure 4A illustre un exemple d'empilement à partir duquel l'on peut mettre en œuvre un exemple de procédé selon l'invention. Dans cet exemple non limitatif plusieurs couches de nitrure, formant chacune une vignette, sont formées sur un substrat.
La figure 4B illustre l'empilement de la figure 4A sur lequel une couche d'amorçage est formée.
La figure 4C illustre le résultat d'une étape consistant à former des ensembles de plots à partir de l'empilement de la figure 4A ou de celui de la figure 4B.

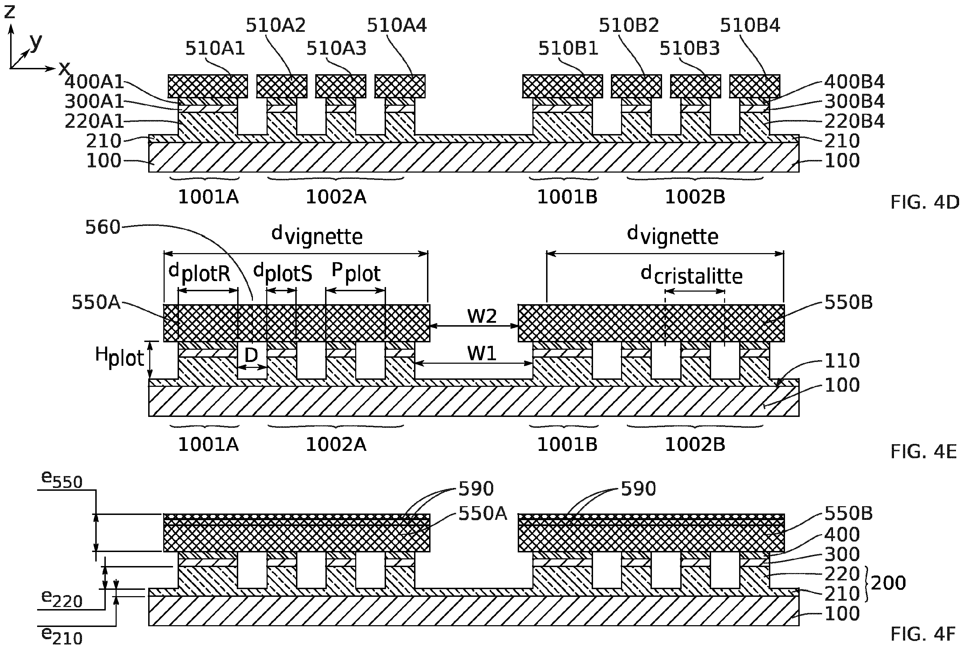

La figure 4D illustre une phase de croissance épitaxiale de cristallites sur le sommet des plots, cette phase de croissance n'étant pas achevée.
La figure 4E illustre le résultat de la croissance épitaxiale de cristallites, après coalescence des cristallites portées par des plots d'un même ensemble, les cristallites portées par des plots d'un même ensemble formant alors une vignette.
La figure 4F illustre une étape optionnelle de réalisation de multi puits quantiques au sein de chaque vignette de nitrure.

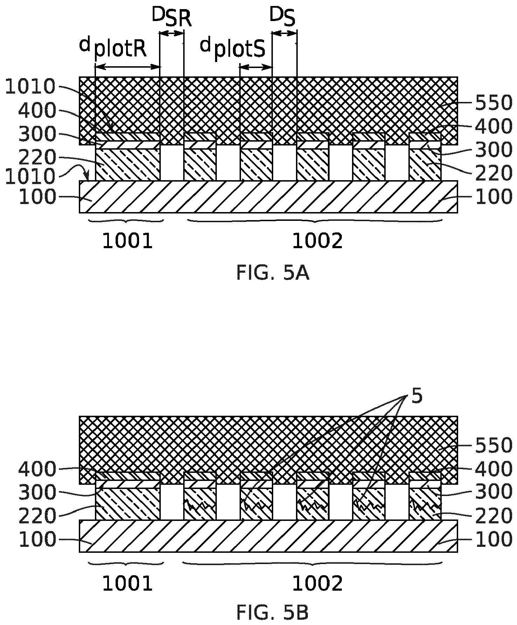

La figure 5A illustre de manière schématique, une vue en coupe d'un empilement comprenant une couche de nitrure formée sur un ensemble de plots selon un mode de réalisation de la présente invention. Dans ce mode de réalisation, au moins l'un des plots présente une section supérieure à celle des autres plots.
La figure 5B illustre, de manière schématique, l'empilement de la figure 5A, après refroidissement de la couche de nitrure.

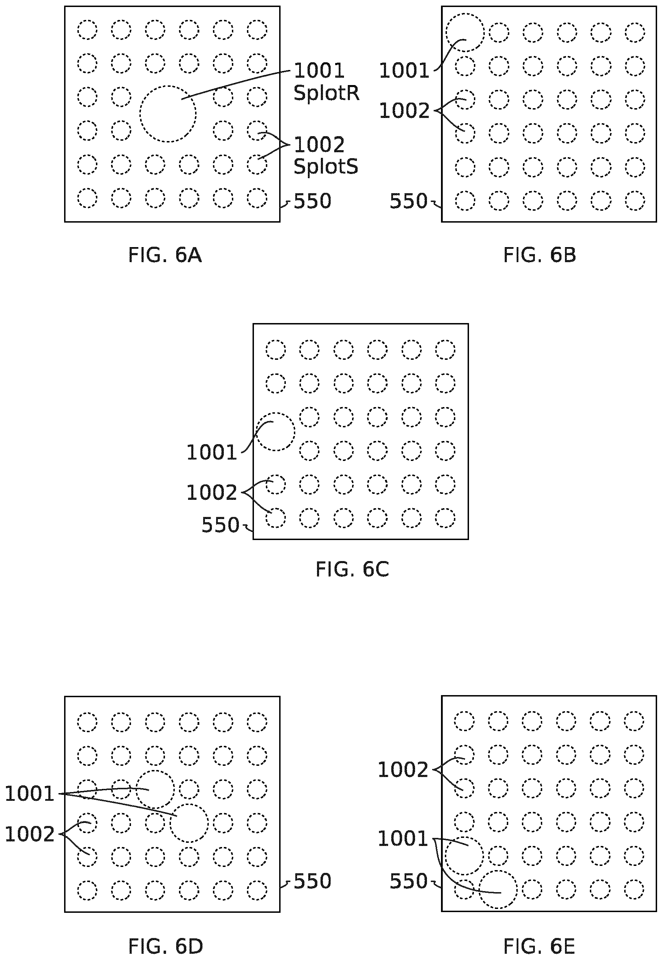

Les figures 6A à 6E illustrent, de manière schématique et en vue du dessus, des exemples d'empilements dans lesquels un ou plusieurs plots présentent une section supérieure à celle des autres plots.

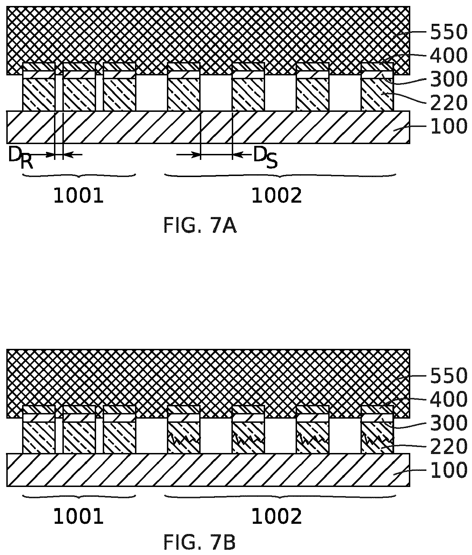

La figure 7A illustre, de manière schématique, une vue en coupe d'un empilement structure comprenant une couche de nitrure formée sur un ensemble de plots selon un mode de réalisation de la présente invention. Dans ce mode de réalisation, au moins certain des plots sont positionnés les uns par rapport aux autres avec une densité plus forte que d'autres plots.

La figure 7B illustre, de manière schématique, l'empilement de la figure 7A, après refroidissement de la couche de nitrure.

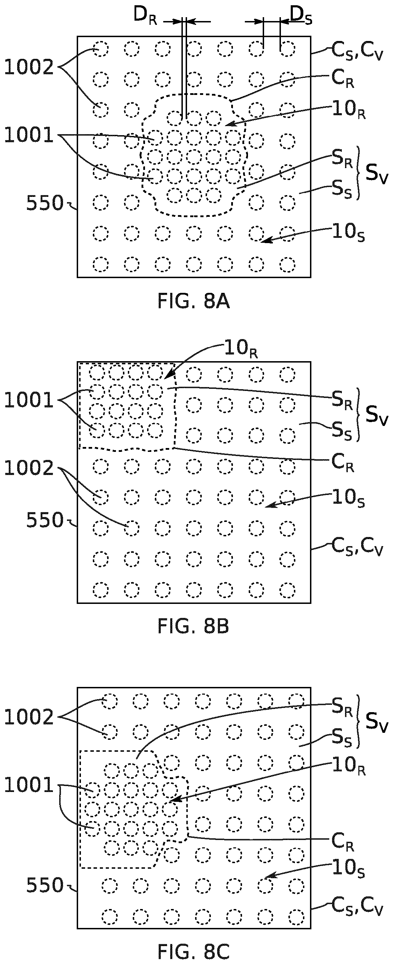

Les figures 8A à 8C illustrent, de manière schématique et en vue du dessus, des exemples d'empilements dans lesquels certains plots sont positionnés les uns par rapport aux autres avec une densité plus forte.

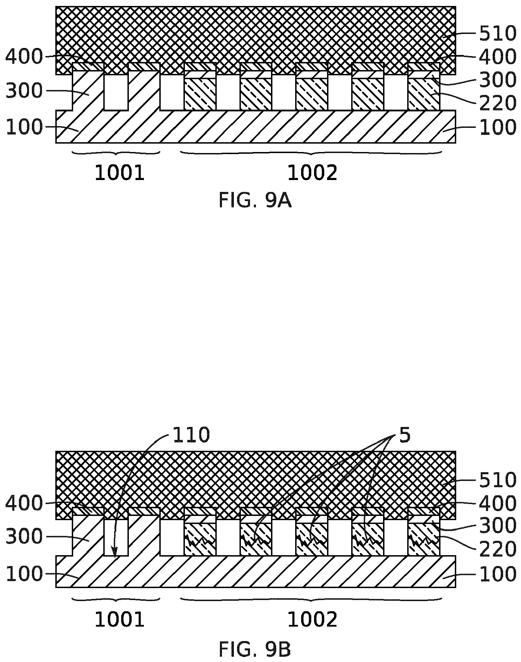

La figure 9A, illustre de manière schématique, une vue en coupe d'un empilement comprenant une couche de nitrure formée sur un ensemble de plots selon un mode de réalisation de la présente invention. Dans ce mode de réalisation, au moins certain des plots comprennent un tronçon de fluage alors que d'autres plots ne comprennent pas de tronçon de fluage.

La figure 9B illustre de manière schématique l'empilement de la figure 9A, après refroidissement de la couche de nitrure.

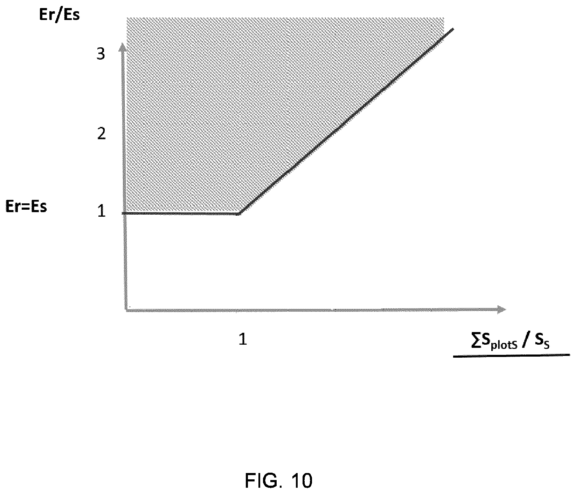

La figure 10 est un graphe sur lequel on peut baser la sélection des paramètres $E_R$, $E_s$, $\Sigma S_{plotS}$, $S_s$, $\Sigma S_{plotR}$, $S_R$ afin de contrôler la rétention de la vignette de nitrure sur le substrat, tout en réduisant, voire en évitant, le risque de fracturation.

Les figures sont données à titre d'exemples et ne sont pas limitatives de l'invention. Elles sont des représentations schématiques de principe destinées à faciliter la compréhension de l'invention et ne sont donc pas nécessairement à la même échelle que les applications pratiques. En particulier, les épaisseurs relatives des différentes couches, tronçons, cristallites et vignettes ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la pluralité de plots de l'ensemble est configurée de sorte que $E_R * \Sigma S_{plotR} > x1 * E_s * \Sigma S_{plots}$. Avec de préférence x1 = 1 ou x1≥1, de préférence x1≥1,5, et de préférence x1≥2.

Selon un exemple, la pluralité de plots de l'ensemble est configurée de sorte que $E_R * \Sigma S_{plotR}/(S_R/S_v)) > x1 * E_S * (\Sigma S_{plots}/S_s/S_v))$. Avec de préférence x1 = 1 ou x1≥1, de préférence x1≥1,5, et de préférence x1≥2. Dans ces équations :

- $\Sigma S_{plotR}$ est la somme des surfaces sommitales de l'au moins un plot de rétention; $\Sigma S_{plotS}$ est la somme des surfaces sommitales des plots de séparation;
- $E_R$ est l'énergie nécessaire pour fracturer une unité de surface de l'au moins un plot de rétention, $E_s$ est l'énergie nécessaire pour fracturer une unité de surface des plots de séparation,
- $S_R$ est une surface d'une zone du substrat présentant un contour $C_R$ entourant l'au moins un plot de rétention de l'ensemble; $S_s$ est une surface d'une zone du substrat présentant un contour $C_s$ entourant les plots de séparation de l'ensemble, la somme de $S_s$ et $S_R$ étant égale à la surface $S_v$ d'une zone du substrat présentant un contour $C_v$ entourant les plots de rétention et les plots de séparation de l'ensemble, le contour $C_v$ formant un unique contour fermé.

Les contours $C_R$ et $C_s$ sont pris de sorte à ce lorsqu'un plot de rétention et un plot de séparation sont adjacents, les contours $C_R$ et $C_s$ sont situés équidistance du plot de rétention et du plot de séparation.

Selon un exemple $E_R > E_s$ et de préférence $E_R > 2 * E_s$. Dans ce cas, selon un exemple, l'au moins un plot de rétention ne présente pas de tronçon de fluage ou présente un tronçon de fluage moins épais ou moins viscoplastique que celui des plots de séparation.

Lorsque $E_R > E_S$, selon un exemple $* (\Sigma S_{plotR}/S_R) = \Sigma S_{plotS}/S_S)$.

Lorsque $E_R > E_s$, selon un exemple $(S_{plotR}/D_R) = (S_{plotS}/D_S)$.

Selon un autre exemple, $E_R = E_S$. Dans ce cas, $(\Sigma S_{plotR}/S_R) > (\Sigma S_{plotS}/S_S)$.

Selon un exemple, $S_{plotR}/D_R > S_{plotS}/D_s$ et de préférence $S_{plotR}/D_R > 2 * S_{plotS}/D_s$. De préférence $S_{plotR}/D_R > 3 * S_{plotS}/D_S$.

- Selon un premier exemple, la surface sommitale $S_{plotR}$ de l'au moins un plot de rétention est supérieure, de préférence à au moins 2 fois, une surface sommitale $S_{plotS}$ des plots de séparation. Si le plot de rétention présente une section circulaire, son diamètre est supérieur à celui des plots de séparation.
- Selon un deuxième exemple, alternatif ou combinable au premier exemple, une distance $D_R$ qui sépare l'au moins un plot de rétention des plots qui lui sont adjacents est inférieure, de préférence d'au moins 1,5 fois, à la distance $D_s$ séparant les plots de séparation de l'ensemble. Si la surface sommitale $S_{plotR}$ des plots de rétention est égale à la surface sommitale $S_{plotS}$ des plots de séparation, alors, on prévoit plusieurs plots de rétention qui sont répartis de manière plus dense que les plots de séparation.

Selon un exemple, $D_s$ est une distance moyenne qui sépare les plots de séparation de tous les plots qui lui sont adjacents. Selon un exemple, $D_R$ est une distance moyenne qui sépare l'au moins un plot de rétention de tous les plots qui lui sont adjacents.

Selon un exemple lorsque $S_{plotR}/D_R > S_{plotS}/D_S$, ou $(\Sigma S_{plotR}/S_R) > (\Sigma S_{plotS}/S_S)$, alors $E_R = E_s$. Ainsi, si les plots de rétention et de séparation présentent les mêmes hauteurs et sections, une même énergie provoque leur fracturation. De préférence, les plots sont formés de tronçons présentant des hauteurs et des matériaux identiques. Cela permet de former tous les plots à partir des mêmes couches et de faciliter le procédé de fabrication.

Selon un exemple, pour chaque ensemble, les plots de rétention sont répartis sur une surface $S_R$ de la couche de nitrure formée sur ledit ensemble de plots inférieure à 30% et de préférence inférieure à 10% de la surface totale $S_{vignette}$ de la couche de nitrure. La surface $S_{vignette}$ est mesurée dans un plan parallèle à un plan (xy) dans lequel s'étend principalement une face supérieure du substrat.

Selon un exemple, le nombre de plots de rétention est inférieur de 50% et de préférence inférieur de 30% au nombre total de plots de l'ensemble, par exemple dans le cas où tous les plots ont le même diamètre.

Selon un exemple, dans la zone de rétention les plots présentent des diamètres plus importants que dans la zone de séparation et des distances entre plots plus faibles que dans la zone de séparation. Par exemple, l'au moins un plot de rétention diffère des plots de séparation au moins par les deux paramètres suivants au moins : $S_{plotR} \geq 1{,}2$ *

$S_{plotS}$, et $D_R * 1{,}2 \leq D_S$.

Selon un exemple, chaque ensemble comprend au moins 36 plots, par exemple pour les vignettes de $3 \times 3$ $\mu m^2$, le nombre de plots de rétention étant inférieur à 4. De préférence le nombre de plots de rétention est inférieur à trois. De préférence le nombre de plots de rétention est inférieur ou égal à 2. De préférence il y a un unique plot de rétention par ensemble.

Selon un exemple, chaque ensemble, comprend un unique plot de rétention. Selon un exemple alternatif, chaque ensemble comprend plusieurs plots de rétention et la somme $\Sigma S_{plotR}$ des surfaces sommitales $S_{plotR}$ des plots de rétention de chaque ensemble est comprise entre 0.000001 et 0.43 fois la somme $\Sigma S_{plotS}$ des surfaces sommitales $S_{plotS}$ des autres plots, par exemple dans le cas où tous les plots ont le même diamètre.

Selon un exemple, $25 \leq d_{plotR}/d_{plotS} \leq 10$ avec $d_{plotR}$ et $d_{plotS}$ étant respectivement la dimension maximale, par exemple le diamètre, de la section d'un plot de rétention et d'un plot de séparation. $d_{plotR}$ et $d_{plotS}$ sont mesurées dans des plans parallèles à la face supérieure du substrat.

Selon un exemple, chaque ensemble comprend au moins une zone, dite zone de rétention, comprenant les plots de rétention et comprend au moins une autre zone, dite zone de séparation, comprenant les plots de séparation. Selon un exemple, la zone de rétention s'étend sur une surface inférieure à 1/3 et de préférence inférieure à 1/10 de la surface de la zone de séparation.

Selon un exemple, la zone de rétention est située en bordure de l'ensemble. Ainsi, la zone de rétention n'est pas entourée par une zone de séparation. Cela permet de contrôler avec plus de fiabilité la séparation d'une partie de la couche de nitrure et la rétention d'une autre partie de la couche de nitrure.

Selon un exemple, la zone de rétention est située en bordure de l'ensemble. Selon un exemple, de préférence, tous les plots de rétention d'un ensemble sont situés dans une unique zone, continue. Ainsi, la zone de rétention n'est pas discontinue. Elle n'est pas séparée par des zones comprenant des plots qui ne sont pas des plots de rétention.

Selon un exemple, la surface totale $S_v$ de la couche de nitrure formée par épitaxie sur un ensemble de plots est égale à la somme de la surface de la zone de rétention $S_R$ additionnée de la surface de la zone de séparation $S_s$. Dans la zone de séparation $S_s$ il n'y a que des plots de séparation. Dans la zone de rétention $S_R$ il n'y a que des plots de rétention.

La zone de rétention peut être continue ou non. Ainsi, si la couche de nitrure, typiquement une vignette comporte plusieurs zones de rétention, $S_R$ peut être égale à la somme des surfaces de ces plusieurs zones de rétention. Il en est de même pour la zone de séparation qui peut être continue ou non.

Selon exemple, les zones de rétention et de séparation diffèrent par une densité de surface occupée par l'au moins un plot de rétention sur la couche de nitrure relativement à une densité de surface occupée par les plots de séparation sur la couche de nitrure. La densité de surface de la couche de nitrure occupée par les plots de rétention dans la zone de rétention est supérieure à la densité de surface de la couche de nitrure occupée par les plots de séparation dans la zone de séparation. Ainsi, le rapport

$$R_{Densité} = [(\textstyle\sum S_{plotR} / S_R) / (\textstyle\sum S_{plotS} / S_S)] > 1,$$

avec :

- $\sum S_{plotR}$ est la somme de l'au moins une surface sommitale de l'au moins un plot de rétention;
- $S_R$ est la surface de la zone de rétention;
- $\sum S_{plotS}$ est la somme de l'au moins une surface sommitale des plots de séparation;
- $S_s$ est la surface de la zone de séparation.

De préférence, $R_{Densité} = [(\sum S_{plotR} / S_R) / (\sum S_{plotS} / S_S)] > 1{,}5$ et de préférence

$$R_{Densité} = [(\textstyle\sum S_{plotR} / S_R) / (\textstyle\sum S_{plotS} / S_S)] > 3.$$

Selon un exemple, de préférence pour une période fixe de plots, la surface sommitale $S_{plotR}$ de l'au moins un plot de rétention est supérieure à au moins 1,5 fois, de préférence à au moins 3 fois la surface sommitale $S_{plots}$ d'un plot de séparation. Les surfaces sommitales $S_{plotR}$ et $S_{plots}$ sont mesurées dans un plan parallèle à un plan (xy) dans lequel s'étend principalement une face supérieure du substrat.

En notant $d_{plotR}$ et $d_{plotS}$ les dimensions maximales de la section des plots de rétention et de séparation respectivement, selon un exemple, 100 nm $\leq d_{plotR}$ $\leq$ 500 nm et 50 nm $\leq d_{plotS} \leq$ 200 nm.

Selon un exemple, chaque ensemble, comprend un unique plot présentant une surface sommitale $S_{plotR}$.

Selon un exemple, de préférence en supposant que les plots ont une même surface, la distance $D_s$ est supérieure à au moins 1,5 fois, de préférence supérieure à au moins 2 fois, et de préférence supérieure à au moins 5 fois la distance $D_R$. Les distances $D_R$ et $D_s$ sont mesurées dans un plan parallèle à un plan (xy) dans lequel s'étend principalement une face supérieure du substrat.

Selon un exemple, 50nm $\leq D_R \leq$ 650 nm et 250 nm $\leq D_S \leq$ 1000 nm.

Selon un exemple, chaque ensemble, comprend un unique plot présentant une distance $D_R$ avec l'un au moins des plots qui leur sont adjacents.

Selon un exemple, les plots de rétention et de séparation sont configurés de sorte à vérifier au moins deux et de préférence au moins trois des relations suivantes :

- $E_R \neq E_s$,
- $D_R \neq D_s$,
- $S_{plotR} \neq S_{plotS}$.

Selon un exemple, chacune de ces couches présente une face inférieure et une face supérieure, sensiblement parallèle à une face supérieure du substrat. Chaque couche forme une vignette. Toutes les faces inférieures des couches sont sensiblement comprises dans un même plan. Il en est de même pour les faces supérieures.

La surface sommitale, destinée à former une couche de germination peut être constituée par le tronçon cristallin, une couche tampon ou encore une couche d'amorce.

Au moins les plots de séparation comprennent un tronçon de fluage, formé en un matériau présentant une température de transition vitreuse $T_{transition}$ vitreuse. Le tronçon cristallin surmonte le tronçon de fluage. Le tronçon de fluage est en un matériau amorphe.

Selon un exemple, la croissance par épitaxie est effectuée à une température $T_{épitaxie}$, telle que : $T_{épitaxie} \geq k1 \times T_{transition\ vitreuse}$, avec k1 $\geq$ 0,8.

Selon un exemple, la couche de fluage est faite d'un matériau visqueux. Ce matériau est de préférence amorphe. Il présente une transition visco-plastique. Il peut ainsi être qualifié de viscoplastique, sa viscoplasticité pouvant être caractérisée par sa température de transition visqueuse. De préférence ce matériau est pris parmi :

- un oxyde de silicium SixOy, x et y étant des entiers, et de préférence la couche de fluage est en $SiO_2$,

- un verre,
- un verre en borosilicate,
- un verre en borophosphosilicate (BPSG).

Selon un exemple, la croissance épitaxiale étant effectuée à une température $T_{épitaxie}$, telle que : $T_{épitaxie} \geq k1 \times T_{transition}$ vitreuse, avec k1 $\geq$ 0,8

De manière optionnelle, la croissance épitaxiale est effectuée à une température $T_{épitaxie}$, telle que : $T_{épitaxie} \geq k1 \times T_{transition}$ vitreuse, avec k1 $\geq$ 0,8.

Selon un exemple, k1 = 1, et de préférence k1 = 1,5. Selon un exemple de réalisation, k1 = 0.87 ou k1 = 0.9. Selon un exemple particulièrement avantageux, k1 = 0.92. Ainsi, dans le cas où les tronçons de fluage sont formés en $SiO_2$, $T_{épitaxie} \geq$ 1104°C, Transition vitreuse pour le $SiO_2$ étant égale à 1200°C. Selon un exemple de réalisation encore plus préférentiel, k1 = 0.95. Selon un exemple de réalisation encore plus préférentiel, k1 = 1, et de préférence k1 = 1,5.

Selon un exemple, $T_{épitaxie} \leq k2 \times T_{fusion\ min}$, $T_{fusion\ min}$ étant la température de fusion la plus faible parmi les températures de fusion des tronçons formant le plot, avec k2 $\leq$ 0,9 et de préférence k2 $\leq$ 0,8. Selon un exemple de réalisation, k2 = 0.9. Cela permet d'éviter une diffusion des espèces du matériau dont la température de fusion est la plus faible. Ainsi, dans le cas où le plot est formé de tronçons de fluage en $SiO_2$ et de tronçons cristallins en silicium, $T_{épitaxie} \leq$ 1296°C. En effet, $T_{fusion\ min}$ est égale à la température de fusion du silicium puisque la température de fusion du silicium est égale à 1440° et la température de fusion du $SiO_2$ est égale à 1970°C. De préférence, k2 = 0.8.

Dans le mode de réalisation dans lequel les plots sont répartis sur le substrat de manière à former une pluralité d'ensembles de plots et que l'étape de croissance par épitaxie est interrompue avant que des cristallites appartenant à deux ensembles distincts n'entrent en coalescence, de sorte à ce que la couche formée sur chaque ensemble forme une vignette, les vignettes étant distantes les unes des autres, le procédé peut présenter au moins l'une quelconque des caractéristiques et étapes suivantes qui peuvent être combinées ou prises séparément :

- Selon un exemple, la distance D (D1 ou D2) séparant deux plots adjacents d'un même ensemble est inférieure à la distance W1 séparant deux plots adjacents appartenant à deux ensembles différents. W1 > D et de préférence W1 $\geq$ 2 x D.
- Selon un exemple, W1 $\geq$ k4 x D, avec k4 = 1.5, de préférence k4 = 2. Cela permet d'avoir des pixels de petites tailles et une densité d'intégration importante dans le cas de la réalisation de micro-LED. De préférence k4= 5. W1 peut être égale à 1,5 micron.
- W2 étant la distance séparant deux vignettes adjacentes (voir W2 en figure 3D), il faut que W2 soit non nulle pour que les deux vignettes adjacentes ne se touchent pas. Ainsi, W2 > 0. Selon un exemple, W1

$\geq$ k5 x W2, avec :

- W1 est la distance séparant deux plots adjacents appartenant à deux ensembles distincts ;
- W2 est la distance séparant deux vignettes adjacentes, W2 étant > 0. De préférence k5 = 1.2, de préférence k5 = 1.5, de préférence k5 = 2.

Selon un exemple, chaque plot présente une section dont la dimension maximale $d_{plot}$ est comprise entre 10 et 500 nm ($10^{-9}$ mètres), la dimension maximale $d_{plot}$ étant mesurée dans un plan parallèle à un plan (xy) dans lequel s'étend principalement une face supérieure du substrat, de préférence 20 nm $\leq d_{plot} \leq$ 200 nm et de préférence 50 nm $\leq d_{plot} \leq$ 100 nm. $d_{plot} = d_{plotR}$ ou $d_{plotS}$.

Selon un exemple, chaque vignette présente une section dont la dimension maximale $d_{vignette}$ est comprise entre 0,5 à 20 $\mu$m ($10^{-6}$ mètres), la dimension maximale $d_{vignette}$ étant mesurée dans un plan parallèle à un plan (xy) dans lequel s'étend principalement une face supérieure du substrat, de préférence 0.8 $\mu$m $\leq d_{vignette} \leq$ 3 $\mu$m et de préférence 1 $\mu$m $\leq d_{vignette} \leq$ 2 $\mu$m. La dimension maximale $d_{vignette}$ correspond ainsi à la dimension maximale d'une projection de la vignette dans un plan parallèle au plan xy dans lequel s'étend principalement la face supérieure du substrat.

Alternativement, les plots d'un même ensemble sont répartis sur le substrat de manière non périodique. De manière optionnelle mais avantageuse, les vignettes sont réparties sur le substrat de manière périodique.

Selon un exemple, les plots comprennent au moins une couche tampon surmontant le tronçon cristallin, et faite en un matériau différent de celui des vignettes de nitrure. Selon cet exemple, les vignettes de nitrure sont faites en nitrure de gallium (GaN) et la couche tampon est en nitrure d'aluminium (AlN). Cela permet, d'éviter l'apparition du phénomène de melt back etching (gravure par refusion), généré par la très forte réactivité entre le gallium et le silicium.

Selon un exemple, la couche tampon est formée par un dépôt par épitaxie au-dessus de la couche cristalline, avant l'étape de formation des plots par gravure. Ainsi, l'empilement comprend, avant l'étape de croissance épitaxiale des vignettes de nitrure, au moins ladite couche tampon. Le fait de former la pluralité de plots par gravure après la formation de la couche tampon au-dessus de la couche cristalline, permet d'éviter que la couche tampon ne se dépose entre les plots, typiquement sur le fond de la couche de fluage ou ne se dépose sur les parois des tronçons formés par la couche cristalline, ce qui aurait été le cas si cette étape de formation de la couche tampon avait été réalisée après gravure de l'empilement pour former les plots. On évite ainsi la croissance épitaxiale des vignettes de nitrure à partir de la couche de fluage. Naturellement, on observe cet avantage lorsque la croissance de la couche de nitrure destinée à former chaque vignette s'effectue par épitaxie de manière sélective. Cette croissance s'effectue en effet sur le matériau de la couche tampon mais ne s'effectue pas sur le matériau des tronçons de fluage. Tel est le cas lorsque ces derniers sont en $SiO_2$, la couche tampon est en AlN et la vignette de nitrure formée par épitaxie, par exemple selon une technique MOVPE (épitaxie en phase vapeur aux organométalliques), est du GaN. Ainsi ce dernier ne se dépose pas au pied des plots.

Selon un exemple, les plots comprennent, avant l'étape de croissance épitaxiale des vignettes de nitrure, au moins une couche d'amorçage, surmontant ladite couche tampon et faite de nitrure de gallium (GaN).

Selon un exemple, l'empilement comprend, avant ladite étape de formation des plots par gravure, au moins une couche d'amorçage, surmontant le tronçon cristallin, la couche d'amorçage étant faite du même matériau que celui des vignettes de nitrure. Ainsi, dans un mode de réalisation dans lequel les vignettes de nitrure sont du GaN, la couche d'amorçage est également en GaN. Avantageusement, cette couche d'amorçage permet de faciliter la reprise de la croissance épitaxiale pour la formation des cristallites. Cette caractéristique est d'autant plus avantageuse que la surface du sommet des plots est faible.

Selon un exemple, chaque plot présente une face supérieure et la croissance par épitaxie des cristallites s'effectue en partie au moins et de préférence uniquement à partir de ladite face supérieure. De préférence, la couche tampon est disposée directement au contact de la face supérieure du tronçon cristallin ou au contact de la face supérieure du tronçon formé par la couche d'amorçage.

Si le sommet du plot, c'est-à-dire la face supérieure du plot découverte, est formé par le tronçon cristallin, alors on fait croître par épitaxie les cristallites directement au contact de la couche cristalline. Si le sommet du plot est formé par la couche d'amorçage, alors on fait croître par épitaxie les cristallites directement au contact de la couche d'amorçage. Si le sommet du plot est formé par la couche tampon, alors on fait croître par épitaxie les cristallites directement au contact de la couche tampon. De préférence, la couche d'amorçage est disposée directement au contact de la face supérieure du tronçon cristallin.

Selon un exemple, au moins l'une parmi la couche tampon et la couche d'amorçage conserve une épaisseur constante au cours de l'étape de croissance par épitaxie.

Selon un exemple, fournir ledit empilement comprend fournir un substrat élaboré de type silicium sur isolant (SOI) comprenant un substrat de base surmonté successivement d'une couche d'oxyde formant ladite couche de fluage et d'une couche semi conductrice formant ladite couche cristalline.

Selon un exemple, le tronçon de fluage présente une hauteur $e_{220}$ telle que $e_{220} \geq 0.1 \times d_{plot}$, $d_{plot}$ étant le diamètre du plot ou plus généralement la distance bord à bord du plot prise, au niveau du tronçon de fluage et dans une direction parallèle à un plan (xy) dans lequel s'étend principalement une face supérieure du substrat, de préférence $e_{220} \geq 1xd_{plot}$. Ces valeurs, permettent d'obtenir une déformation suffisante pour réduire les contraintes au niveau du joint de grain.

Selon un exemple, les plots présentent une hauteur $H_{plot}$, et dans lequel deux plots adjacents sont distants d'une distance D, telle que : $H_{plot} / D < 2$ et de préférence $H_{plot} / D \leq 1$.

Selon un exemple, le tronçon cristallin est à base de silicium et de préférence le tronçon cristallin est en silicium.

Le tronçon cristallin peut être aussi à base de matériaux autres que le Si et qui permettent l'épitaxie de matériaux nitrures. Par exemple, le tronçon cristallin peut être à base de SiC ou de $Al_2O_3$. Ces matériaux sont en outre utilisables sous la forme de SiCOI (SiC on Insulator, c'est-à-dire de SiC sur isolant) ou de SOS (silicium sur saphir).

Selon un exemple de réalisation la couche cristalline ayant servie à former le tronçon cristallin est une couche mono-cristalline.

Selon un exemple de réalisation, la couche de fluage est au contact direct avec le substrat. La couche de fluage est au contact direct du tronçon cristallin. Selon un exemple de réalisation, la couche de nitrure formant chaque vignette que l'on réalise par coalescence de cristallites est au contact direct du tronçon cristallin. Selon un autre mode de réalisation, on prévoit au moins une couche intermédiaire entre le tronçon cristallin et la couche de nitrure que l'on réalise par coalescence de cristallites et qui forme une vignette. Cette couche intermédiaire forme typiquement la couche tampon.

Ainsi, la couche de fluage et la couche cristalline sont différentes. La couche de fluage présente une température de transition vitreuse. Elle est donc faite d'un matériau à transition vitreuse et présente le comportement des matériaux à transition vitreuse. Ainsi, la couche de fluage n'est pas cristalline. Elle est faite d'un matériau visqueux ou vitreux, par exemple d'un oxyde. La couche de fluage et la couche cristalline ne sont pas faites du même matériau.

Selon un exemple de réalisation, la couche de fluage présente une épaisseur $e_{220}$ inférieure à 500nm ($10^{-9}$ mètres). Elle est de préférence comprise entre 50 nm et 500 nm et de préférence entre 100 nm et 150 nm.

Selon un exemple de réalisation, la couche cristalline présente une épaisseur comprise entre 2 nm ($10^{-9}$ mètres) et 10 $\mu$m ($10^{-6}$ mètres) et de préférence entre 5nm et 500 nm et de préférence entre 10 nm et 50nm.

Selon un exemple de réalisation, on fait croitre par épitaxie des cristaux sur tous les plots.

Selon un exemple de réalisation, le rapport V/III des flux dans le réacteur de dépôt par épitaxie (les flux étant par exemple mesurés en sccm) dudit matériau comprenant du nitrure (N) et au moins l'un parmi le gallium (Ga), l'Indium (In) et l'aluminium (Al) est de l'ordre de 2000.

Selon un exemple de réalisation, le nitrure des vignettes est un nitrure de gallium (GaN). Selon un autre mode de réalisation, le nitrure des vignettes est à base de nitrure de gallium (GaN) et comprend en outre de l'aluminium (Al) et/ou de l'indium (In).

Selon un autre mode de réalisation, le matériau formant le nitrure (N) des vignettes est l'un quelconque parmi: le nitrure de gallium (GaN), le nitrure d'indium (InN), le nitrure d'aluminium (AIN), le nitrure d'aluminium gallium (AIGaN), le nitrure d'indium gallium (InGaN), le nitrure d'aluminium gallium indium (AIGaInN), le nitrure d'aluminium indium (AIInN), le nitrure d'aluminium indium Gallium (AIInGaN).

Selon un exemple, l'étape de formation des plots comprend la gravure de la couche cristalline et la gravure d'une portion seulement de la couche de fluage de manière à conserver une portion de la couche de fluage entre les plots.

Selon un exemple, l'étape de formation des plots est effectuée de sorte que $d_{cristallite}/ d_{plot} \geq k3$, avec k3 = 3, $d_{plot}$ étant la dimension maximale de la section du plot prise dans une direction parallèle à un plan (xy) dans lequel s'étend principalement une face supérieure du substrat (plot ou plus généralement la distance bord à bord du plot, c'est-à-dire la dimension maximale du plot quelle que soit la forme de sa section), $d_{cristallite}$ correspondant à la dimension de la cristallite mesurée selon la même direction que $d_{plot}$ au moment de la coalescence des cristallites.

Des résultats particulièrement efficaces ont été obtenus pour k3 = 3. Selon un exemple $100 \geq k3 \geq 3$. De préférence, $50 \geq k3 \geq 3$. De préférence, $5 \geq k3 \geq 3$.

Cette caractéristique permet aux tronçons de fluage de se déformer pour encaisser de manière particulièrement efficace les contraintes mécaniques qui naissent lorsque deux cristallites adjacentes commencent à coalescer. Ainsi, cette caractéristique contribue efficacement à réduire la densité de défauts au sein des vignettes de nitrure que l'on obtient au final.

De préférence, $P_{plot}/d_{plot} \geq 4$, et de préférence $P_{plot}/d_{plot} \geq 5$. Selon un exemple qui donne des résultats particulièrement qualitatifs, $P_{plot}/d_{plot} = 5$.

Le terme « micro-LED » désigne une LED dont au moins une dimension prise dans un plan parallèle au plan principal dans lequel s'étend le substrat supportant la micro-LED (i.e., le plan xy du repère orthogonal référencé sur les figures) est micrométrique, c'est-à-dire strictement inférieure à 1 mm ($10^{-3}$ mètres). Dans le cadre de l'invention les micro-LED présentent, en projection dans un plan d'extension principal parallèle aux faces principales des micro-LED, i.e., parallèle à une face supérieure du substrat, des dimensions maximales de dimension micrométrique dans le plan. De préférence, ces dimensions maximales sont inférieures à quelques centaines de micromètres. De préférence, ces dimensions maximales sont inférieures à 500 $\mu$m et de préférence inférieures à 100 $\mu$m.

Dans la présente invention, on entend par « transistors de type HEMT » (acronyme anglais de « High Electron Mobility Transistor») des transistors à effet de champ à haute mobilité d'électrons, parfois également désignés par le terme de transistor à effet de champ à hétérostructure. Un tel transistor inclut la superposition de deux couches semiconductrices ayant des bandes interdites différentes qui forment un puits quantique à leur interface. Des électrons sont confinés dans ce puits quantique pour former un gaz bidimensionnel d'électrons. Pour des raisons de tenue en haute tension et en température, les matériaux de ces transistors sont choisis de façon à présenter une large bande d'énergie interdite.

Dans la suite de la description, les termes cristaux et cristallites seront considérés comme équivalents.

Il est précisé que dans le cadre de la présente invention, les termes « sur », « surmonte », « recouvre » ou « sous-jacent » ou leurs équivalents ne signifient pas « au contact de ». Ainsi par exemple, « le dépôt d'une première couche sur une deuxième couche » ne signifie pas obligatoirement que les deux couches sont directement au contact l'une de l'autre mais cela signifie que la première couche recouvre au moins partiellement la deuxième couche en étant soit directement à son contact, soit en étant séparée d'elle par au moins une autre couche ou au moins un autre élément y compris de l'air. De même, « un plot surmontant une première couche » ne signifie pas que le plot est nécessairement au contact de cette première couche mais signifie que le plot est, soit au contact de cette première couche, soit au contact d'une ou plusieurs couches disposées entre la première couche et le plot.

Les étapes de formation des différentes couches et régions s'entendent au sens large : elles peuvent être réalisées en plusieurs sous-étapes qui ne sont pas forcément strictement successives.

Dans la description qui suit, l'épaisseur ou la hauteur est prise selon une direction perpendiculaire aux faces principales des différentes couches. Sur les figures, l'épaisseur ou la hauteur est prise selon la verticale ou selon l'axe z du repère orthogonal illustré en figure 4A.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement (axe z) sur les figures.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de $90 \pm 10°$ par rapport au plan.

Un exemple de procédé de formation d'une couche de nitrure va maintenant être décrit en référence aux figures 4A à 4F. Dans cet exemple non limitatif, on réalise à la surface d'un substrat une pluralité de couches formant chacune une vignette.

Comme illustré en figure 4A, on fournit un empilement comprenant au moins un substrat 100, surmonté successivement d'une couche de fluage 200 et d'une couche cristalline 300. Ainsi la couche de fluage 200 est disposée entre le substrat 100 et la couche cristalline 300.

Selon un exemple de réalisation, le substrat 100 est à base de silicium, amorphe ou cristallin. Il assure la tenue mécanique de l'empilement.

La couche cristalline 300 présente une face inférieure en regard de la couche de fluage 200 et une face supérieure dont la fonction est de servir de couche de base pour faire croître des vignettes 550A, 550B de nitrure. Par exemple, la couche que l'on souhaite obtenir au final est une couche de nitrure de gallium GaN. Selon un exemple de réalisation, la couche cristalline 300 est à base de silicium monocristallin. Alternativement la couche cristalline 300 peut être à base de SiC ou de $Al_2O_3$.

De préférence, la couche de fluage 200 est faite d'un matériau amorphe. Ce matériau est visqueux. La couche de fluage 200, présente une température de transition vitreuse. Elle présente donc une transition vitreuse et présente le comportement des matériaux à transition vitreuse. Comme tous les matériaux présentant une température de transition vitreuse, la couche de fluage 200, sous l'effet d'une élévation de température, se déforme sans rompre et sans reprendre sa position initiale après une baisse de température. Au contraire, la couche cristalline 300 ne présente naturellement pas de transition vitreuse. La couche cristalline se déforme, puis se disloque et peut rompre. Par conséquent, la couche de fluage 200 et la couche cristalline 300 sont différentes. La couche de fluage 200 n'est pas cristalline.

La couche de fluage 200 est faite d'un matériau amorphe tel qu'un oxyde, de préférence un oxyde de silicium SixOy, tel que le SiO2. Le rôle de cette couche sera explicité dans la suite de la description.

De manière avantageuse mais non limitative, cet empilement comprenant le substrat 100, la couche de fluage 200 et la couche cristalline 300 constitue un substrat de type semi-conducteur sur isolant, de préférence de silicium sur isolant (SOI). Dans ce cas, la couche de fluage 200 est formée par la couche d'oxyde enterré (BOX) du substrat SOI.

Selon un exemple de réalisation avantageux illustré en figure 4A, on dépose, par épitaxie sur la face supérieure de la couche cristalline 300, une couche tampon 400. Lorsque les vignettes 550A, 550B que l'on souhaite obtenir au final sont formées de GaN et que la couche cristalline 300 est une couche à base de silicium, cette couche tampon 400 est typiquement en nitrure d'aluminium (AIN). Cela permet d'éviter le phénomène dit de «Melt-back etching» (gravure par refusion), généré par la très forte réactivité entre le silicium et le gallium aux températures usuelles d'épitaxie (1000/1100°C) et qui conduit à dégrader très fortement les vignettes 550A, 550B de GaN.

Typiquement, l'épaisseur de la couche d'AIN est comprise entre 10 et 100 nanomètres ($10^{-9}$ mètres).

Comme illustré en figure 4B, on peut également déposer par épitaxie, sur la face supérieure de la couche tampon 400, une couche d'amorçage 500. Cette couche d'amorçage 500 a pour fonction de faciliter la reprise de croissance des cristallites 510 lors des étapes suivantes. Dans ce cas, c'est à partir d'une face supérieure de la couche d'amorçage 500 que se produit en partie au moins la croissance par épitaxie des cristallites 510A1-510B4, les cristallites étant illustrées en figure 4D. Cette couche d'amorçage 500 est de préférence réalisée dans le même matériau que celui des vignettes 550A, 550B que l'on souhaite obtenir au final. Typiquement, lorsque le matériau des vignettes 550A, 550B est du nitrure de gallium GaN, la couche d'amorçage 500 est également en GaN. Cette couche d'amorçage 500 présente typiquement une épaisseur comprise entre 50 et 200 nanomètres.

Par souci de concision et de clarté, seuls quatre plots 1000A1-1000A4 sont représentés sur les figures pour supporter une vignette 550A. Naturellement, une vignette 550A peut être formée sur un nombre supérieur de plots. Comme cela sera décrit par la suite, le nombre de plots ainsi que leur période sera adaptée en fonction de la taille voulue pour le dispositif micro-électronique, tel qu'une LED, un transistor (de type HEMT par exemple) ou une diode de puissance, que l'on souhaite réaliser à partir de cette vignette.

On notera que les couches 400 et 500 sont uniquement optionnelles. Ainsi, selon des modes de réalisation non illustrés en figure 4A-4F, on pourra prévoir uniquement la couche tampon 400 ou uniquement la couche d'amorçage 500, ou encore aucune de ces deux couches 400 et 500.

Comme illustré en figure 4C, on forme ensuite des plots 1000A1-1000B4 à partir de l'empilement. Ces plots sont obtenus par gravure de l'empilement jusque dans la couche de fluage 200, une partie au moins de la gravure s'étendant au sein de la couche de fluage 200.

Pour former les plots par gravure, on pourra recourir aux nombreuses techniques de gravure connues de l'homme du métier. On pourra notamment utiliser les techniques classiques de lithographie, telles que les techniques de photolithographie comprenant la formation d'un masque, par exemple en résine, puis le transfert des motifs du masque dans l'empilement. On pourra également recourir aux techniques de lithographie par faisceau d'électrons (e-beam) ou aux techniques d'impression nanométrique.

Ces plots 1000A1-1000B4 sont de faibles dimensions et peuvent être qualifiés de nano-plots ou de nano-piliers. Typiquement, la dimension maximale de la section des plots, prise dans un plan parallèle au plan xy du repère orthogonal xyz ou au plan de la face supérieure 110 du substrat 100, est comprise entre quelques dizaines et quelques centaines de nanomètres. Cette dimension est notée $d_{plot}R$, $d_{plot}S$ en fonction des plots. Cette dimension, sera notée $d_{plot}$ lorsqu'elle concerne indifféremment les plots d'un même ensemble (ainsi $d_{plot}S = d_{plot}R$ ou $d_{plot}S$). De préférence, $d_{plot}$ est comprise entre 10 et 1000 nanomètres et de préférence entre 20 et 150 nm et de préférence entre 50 et 100 nm par exemple de l'ordre de 50 nm ou de 100 nm. Cette dimension maximale de la section des plots est référencée $d_{plot}$ en figure 4C. Si les plots sont de section circulaire, cette dimension maximale $d_{plot}$ correspond au diamètre des plots. Si les plots sont de section hexagonale, cette dimension maximale $d_{plot}$ correspond à la diagonale ou au diamètre du cercle passant par les angles de l'hexagone. Si ces plots sont de section rectangulaire ou carrée cette dimension maximale $d_{plot}$ correspond à la plus grande diagonale ou au côté du carré.

On remarque que pour chaque vignette, parmi les plots 1000A, 1000B de chaque ensemble, un ou plusieurs plots, qualifiés de plots de rétention 1001 diffère(nt) des autres plots. Pour les plots 1000A, le plot 1000A1 fait office de plot de rétention et les autres plots 1000A2-1000A4 font office de plots de séparation et sont référencés 1002A2-A4 ou plus généralement 1002. Dans cet exemple illustré en figure 4C, pour chaque vignette, les plots de rétention 1001A, 1001B présentent une section $d_{plotR}$ supérieure à la section $d_{plotS}$ des autres plots 1002A, 1002B de la vignette à laquelle ils appartiennent. Les détails et avantages liés à cette différenciation des plots au sein d'une même vignette seront décrits en détail par la suite.

Les plots 1000A1-1000B4 ne sont pas tous répartis de manière régulière à la surface du substrat 100. Les plots 1000A1-1000B4 forment des ensembles 1000A, 1000B de plots, chaque ensemble comprenant une pluralité de plots. Les plots 1000A1-1000A4 formant un même ensemble 1000A définissent un réseau de plots distant du réseau de plots 1000B1-1000B4 formant un autre ensemble 1000B.

Ainsi, les plots adjacents 1000A1-1000A4 d'un même ensemble 1000A sont distants d'une distance D. Les plots adjacents 1000A4-1000B1 appartenant à deux ensembles 1000A, 1000B distincts sont séparés d'une distance W1. Les distances D et W1 sont prises dans des plans parallèles au plan xy et sont illustrées en figure 4C. Comme cela sera expliqué par la suite, les plots 1000A1-1000A4 d'un même ensemble 1000A sont destinés à supporter une unique vignette 550A qui sera distante d'une autre vignette 550B supportée par un autre ensemble 1000B de plots 1000B1-1000B4.

On notera que pour une même vignette, la distance D peut varier. Ainsi, les plots 1000A1-1000A4 d'une même vignette 550A peuvent être répartis de manière non périodique. Leur répartition peut ainsi être adaptée pour favoriser la croissance de la vignette. Par exemple, si l'agencement des plots 1000A1-1000A4 d'une vignette 550A n'est pas périodique, on peut avoir une distance D qui varie pour ces plots 1000A1-1000A4 de plus ou moins 20% ou de plus ou moins 10% par exemple plus ou moins 10 nm autour d'une valeur moyenne. Selon un exemple, D peut prendre les valeurs suivantes pour une même vignette : 100nm, 90nm, 85nm, 107nm.

Les vignettes 550A, 550B formées sur des ensembles de plots 1000A, 1000B répartis de manière non périodique peuvent quant à elles être disposées de manière périodique sur le substrat. Cela facilite la réalisation d'un micro écran.

Selon un exemple de réalisation, les tronçons des plots 1000A1-1000B4, formés dans la couche de fluage 200, présentent une hauteur e220 et, au sein d'un même ensemble, deux plots adjacents 1000A1, 1000A2 sont distants d'une distance D, telle que :

- e220 / D <1, et de préférence e220 / D <1.5. De préférence e220 / D <2.

Selon un exemple de réalisation, les plots présentent une hauteur $H_{plot}$ et deux plots adjacents sont distants d'une distance D, telle que :

- $H_{plot}$ / D <2 , et de préférence $H_{plot}$ / D <1.5. De préférence $H_{plot}$ / D $\leq$ 1.
- $H_{plot}$ et e220 sont mesurées selon la direction z. D est mesurée parallèlement au plan xy.

Comme illustré en figure 4C, les plots sont gravés à travers toute la couche d'amorçage 500, toute la couche tampon 400 (lorsque ces dernières sont présentes), toute la couche cristalline 300. De préférence, seule une portion 220 de la couche de fluage 200 est gravée. Ce mode de réalisation présente pour avantage d'éviter que lors de l'épitaxie le nitrure des vignettes 550A, 550B se développe sur les tronçons de fluage 220. Cette sélectivité de l'épitaxie se rencontre notamment lorsque les vignettes 550A, 550B de nitrure que l'on fait croître par épitaxie sont en GaN et que les tronçons de fluage sont en SiO2. Au contraire, si, avec ces mêmes matériaux, la couche de fluage 200 est gravée sur toute son épaisseur, alors, lors de l'épitaxie, le nitrure des vignettes 550A, 550B se développe à partir de la face supérieure 110 du substrat 100, habituellement formée de silicium. Cette situation n'est évidemment pas souhaitable.

Par ailleurs, il a été observé que le fait de conserver une portion 210 non gravée de la couche de fluage 200 permet de faciliter le fluage du tronçon 220, en particulier lorsque les cristallites sont désorientées en twist, c'est-à-dire dans des plans principaux d'extension des vignettes 550A, 550B que l'on souhaite obtenir. Ces plans principaux d'extension des vignettes 550A, 550B sont parallèles au plan xy du repère xyz.

De manière préférée, l'épaisseur e220 gravée, et formant donc la hauteur du tronçon de fluage 220, est égale à au moins la moitié de l'épaisseur de la couche de fluage 200. Cela permet d'avoir une très bonne réorientation des cristallites lors de la formation de joints de grains.

La figure 4D illustre la formation de cristallites 510A1-510B4 par croissance épitaxiale à partir de la couche d'amorçage 500 (ou de la face supérieure de la couche cristalline 300 lorsque les couches 400 et 500 sont absentes).

Comme illustré sur cette figure 4D, les plots 1000A1-1000B4 supportent chacun une cristallite 510A1-510B4 portée par un empilement de tronçons 400A1-400B4, 300A1-300B4, 220A1-220B4. Les tronçons s'étendent selon la direction principale d'extension du plot, c'est-à-dire verticalement (z) sur les figures 4A à 4F.

Les tronçons forment des cylindres circulaires si la section des plots est principalement circulaire. Si la section des plots 1000A1-1000B4 est polygonale, par exemple hexagonale, les tronçons forment alors des cylindres de section hexagonale. De préférence, les tronçons sont pleins. La section des plots est prise parallèlement au plan xy, soit parallèlement aux plans dans lesquels la couche de fluage 220 et la couche cristalline 300 s'étendent principalement.

Quel que soit le mode de réalisation retenu, c'est-à-dire avec ou sans couche d'amorçage 500 et avec ou sans couche tampon 400, la croissance par épitaxie des cristallites 510A1-510B4, s'effectue en partie au moins ou uniquement à partir de la face supérieure du plot 1000A1-1000B4, également désignée sommet du plot. Ainsi, cette face supérieure est formée soit par le tronçon cristallin 300A1-300B4, soit par le tronçon formé par la couche d'amorçage 400A1-400B4, soit par le tronçon formé par la couche tampon. Cela permet notamment d'obtenir rapidement des cristallites 510A1-510B4 d'épaisseur importante.

On remarquera que les faces supérieures de la couche tampon 400 et de la couche d'amorçage 500, c'est-à-dire les faces tournées au regard de la couche des vignettes 550A, 550B que l'on souhaite faire croître, présentent des polarités de type Gallium (Ga), et non pas azote (N), ce qui facilite considérablement l'obtention de vignettes 550A, 550B de nitrure épitaxié de grande qualité.

La croissance des cristallites 510A1-510B4 se poursuit et s'étend latéralement, en particulier selon des plans parallèles au plan xy. Les cristallites 510A1-510B4 d'un même ensemble 1000A de plots 1000A1-1000A4 se développent jusqu'à coalescer et former un bloc ou vignettes 550A, 550B comme illustré en figure 4E.

Autrement dit, et comme cela ressort clairement des figures, chaque vignette 550A, 550B s'étend entre plusieurs plots 1000A1-1000A4. Chaque vignette 550A, 550B forme une couche continue.

Cette croissance des cristallites 510A1-510B4 ne s'étend pas vers le bas. Par ailleurs, cette croissance est sélective en ce qu'elle n'a pas lieu sur la couche de fluage 200 typiquement faite d'un oxyde. En ce sens, la croissance des cristallites 510A1-510B4 s'effectue selon le principe de pendeo-épitaxie.

On notera qu'il est particulièrement avantageux de graver les plots 1000A1-1000B4 après formation par épitaxie de la couche tampon 400 et de la couche d'amorçage 500 (lorsque ces couches sont présentes). En effet, si l'une de ces couches 400, 500 était déposée après gravure, elle se formerait en partie au moins entre les plots 1000A1-1000B4 sur la face supérieure de la couche de fluage 200. Dans le cas où le nitrure épitaxié est du GaN, que la couche de fluage 200 est du $SiO_2$, alors, à la température du dépôt par épitaxie, la croissance épitaxiale des vignettes 550A, 550B de nitrure ne s'effectuerait pas de manière sélective mais aurait au contraire également lieu entre les plots 1000A1-1000B4, ce qui naturellement n'est pas souhaitable.

De manière particulièrement avantageuse, la température $T_{épitaxie}$ à laquelle on effectue l'épitaxie est supérieure ou de l'ordre de la température Transition vitreuse de transition vitreuse de la couche de fluage 200. Ainsi, lors de l'épitaxie, les tronçons de fluage 220A1-220A4 sont portés à une température qui leur permet de se déformer.

Par conséquent, si les cristallites 510A1-510A1 portées par deux plots 1000A1-1000A2 adjacents sont désorientées l'une par rapport à l'autre, lors de la coalescence de ces deux cristallites, le joint 560 formé à leur interface, habituellement désigné joint de grains ou joint de coalescence, se formera sans dislocation pour rattraper ces désorientations. La déformation des tronçons de fluage 220 permet ainsi de rattraper ces désorientations et d'obtenir des vignettes 550A, 550B sans ou avec très peu de dislocations aux joints de coalescence. Ce phénomène sera décrit en détail par la suite en référence aux figures 5A à 5D.

Ainsi, à l'issue de l'étape 4E, on obtient une pluralité de vignettes 550A, 550B, chaque vignette 550A étant supportée par les plots 1000A1-1000A4 d'un même ensemble 1000A de plots. Deux vignettes adjacentes 550A, 550B sont séparées d'une distance W2, W2 étant la distance la plus faible prise entre ces deux vignettes. W2 est mesurée dans le plan xy.

W2 dépend de W1, de la durée et de la vitesse de la croissance épitaxiale. W2 est non nulle. W2 < W1.

On note $d_{vignette}$ la dimension maximale d'une vignette mesurée parallèlement au plan xy. Ainsi, $d_{vignette}$ correspond à la dimension maximale d'une projection de la vignette dans un plan parallèle au plan xy. Selon un exemple $0.8 \ \mu m \leq d_{vignette} \leq 3 \ \mu m$. Selon un autre exemple $1 \ \mu m \leq d_{vignette} \leq 2 \ \mu m$. Selon un exemple $d_{vignette}$ est compris entre $10 \mu m$ et $200 \ \mu m$. Tel est le cas par exemple pour les transistors MOSFET verticaux. Selon un exemple $d_{vignette}$ est de l'ordre de $1000 \ \mu m$. Tel est le cas par exemple pour les transistors de puissance de type HEMT. $d_{vignette}$ dépend de la vitesse et de la durée de la croissance épitaxiale ainsi que du nombre, de la dimension et du pas $p_{plot}$ des plots d'un même ensemble.

Le procédé de réalisation des vignettes 550A, 550B peut être stoppé à l'issue de la figure 4E. Alternativement, ce procédé peut être poursuivi pour former un dispositif intégrant la couche de nitrure. Lorsque la couche de nitrure forme une vignette, le procédé peut être poursuivi pour former par exemple une micro-LED, une diode ou un transistor à partir de chacune des vignettes 550A, 550B.

La figure 4F illustre un mode de réalisation non limitatif dans lequel on réalise des puits quantiques 590 au sein de chaque vignette 550A, 550B. Ce mode de réalisation permet avantageusement de réaliser directement une micro-LED de taille correspondant à la taille initiale de la vignette. Pour réaliser des puits quantiques 590 au sein de chaque vignette 550A, 550B, l'homme du métier pourra mettre en œuvre les solutions connues de l'état de la technique. Ainsi, une fois que les cristallites 510 ont coalescé, on adopte les mêmes conditions de croissance pour les puits que lors d'une croissance bidimensionnelle classique.

La plus faible dimension possible pour les micro-LED est fonction de la résolution ultime des méthodes de structuration choisies : par exemple, pour des réseaux élaborés par nanoimpression, on atteint des tailles de plots de 50 nm et des périodes $p_{plot}$ de 150 à 200 nm. Ce qui signifie que l'on obtient des dimensions $d_{vignette}$ de vignettes de 1 à 2 $\mu m$. Ceci est donc de l'ordre des tailles de pixels recherchées pour les $\mu$-display haute résolution.

Dans l'exemple ci-dessus décrit en référence aux figures 4A à 4F, les plots 1000 sont répartis sur le substrat 100 de manière à former des ensembles 1000A, 1000B distincts de sorte à ce qu'une couche de nitrure se forme sur chaque ensemble et que la croissance par épitaxie soit interrompue avant que les différentes couches n'entrent en contact, formant ainsi des vignettes 550A, 550B distinctes et séparées sur le substrat 100.

Naturellement, toutes les caractéristiques, étapes et avantages techniques mentionnés en référence à ce mode de réalisation sont applicables à un mode de réalisation alternatif dans lequel on réalise une unique couche sur le substrat 100. Dans ce cas, on peut prévoir qu'il n'y ait pas de discontinuité entre des ensembles de plots. En tout état de cause, on prévoit de poursuivre la croissance par épitaxie jusqu'à ce qu'une couche continue se forme sur les plots. Dans ce cas, on veillera naturellement à répartir les plots de sorte à ce que la croissance épitaxiale à partir des plots forme cette couche continue. Par exemple W1 = D et W2 = 0. De préférence, cette couche recouvre au moins 50% de préférence au moins 80% de la face supérieure du substrat 100.

Dans chacun de ces deux modes de réalisation, i.e., avec formation d'une unique couche sur le substrat ou formation d'une pluralité de couches formant chacune une vignette, la coalescence s'effectue sans, ou avec peu de dislocations au sein de la couche de nitrure. Dans ces deux modes de réalisation, l'unique couche de nitrure ou certaines au moins des vignettes risque(ent) de se séparer du substrat. Prévoir une zone de rétention pour éviter ce risque de séparation est donc particulièrement avantageux.

## Exemples de caractéristiques pour réduire les dislocations au niveau des joints de coalescence

De manière générale, pour obtenir une coalescence des cristallites sans dislocation, on peut ajuster les paramètres suivants :

- Les propriétés de « rupture mécanique » du matériau formant le tronçon de fluage à haute température sous des contraintes relativement faibles de 500MPa.

- La taille suffisamment petite des plots 1000A1-1000A4 de support comparée à la distance D entre les plots d'un même ensemble 1000A, permet de créer une contrainte dans le tronçon de fluage qui soit, pour un couple de rotation donné, supérieure à la contrainte de rupture.

Par ailleurs, comme indiqué ci-dessus, on veillera à ce que la température d'épitaxie $T_{épitaxie}$ rende possible le fluage du tronçon de fluage 220. En pratique, $T_{épitaxie} \geq 600°C$ (dans le cadre d'une épitaxie par jets moléculaires), $T_{épitaxie} \geq 900°C$ et de préférence $T_{épitaxie} \geq 1000°C$ et de préférence $T_{épitaxie} \geq 1100°C$. Ces valeurs permettent de réduire de manière particulièrement efficace les défauts dans la vignette ou la couche épitaxiée lorsque la couche de fluage est en SiO2. En pratique, $T_{épitaxie} \leq 1500°C$.

Afin de faciliter la formation de joints de coalescence 560 sans dislocation, il sera préférable d'appliquer les conditions suivantes :

- $T_{épitaxie} \geq k1 \times T_{transition\ vitreuse}$, avec k1 = 0.8, de préférence k1 = 1 et de préférence k1 = 1,5.

Selon un exemple de réalisation, $T_{épitaxie} \leq k2x\ T_{fusion\ min}$, $T_{fusion\ min}$ étant la température de fusion la plus faible parmi les températures de fusion des tronçons formant le plot. Il s'agit principalement du tronçon cristallin et du tronçon de fluage. Selon un exemple de réalisation, k2 = 0.9. Cela permet d'éviter une diffusion des espèces du matériau dont la température de fusion est la plus faible.

Ainsi, dans le cas où le plot est formé de tronçons de fluage en $SiO_2$ et de tronçons cristallins en silicium, $T_{épitaxie} \leq 1296°C$. En effet, $T_{fusion\ min}$ est égale à la température de fusion du silicium puisque la température de fusion du silicium est égale à 1440°C et la température de fusion du $SiO_2$ est égale à 1970°C.

Selon un exemple de réalisation, la hauteur $e_{220}$ du tronçon de fluage est telle que e220 $\geq$ 0.1 * $d_{plot}$. Ces valeurs, permettent d'obtenir une déformation suffisante pour réduire les dislocations au niveau du joint de grain. $d_{plot} = d_R$ ou $d_S$. Selon un exemple si $d_{plot} = d_R$, alors e220 $\leq$ 1*$d_{plot}$, de préférence e220 $\leq$ 0,5 * $d_{plot}$.

Les plots 1000A1-1000A4 présentent une hauteur $H_{plot}$, et deux plots 1000A1-1000A2 adjacents sont distants d'une distance D, telle que : $H_{plot}$/ D < 2 et de préférence $H_{plot}$ / D $\leq$1. $D_{plot} = D_R$ ou $D_s$. Selon un exemple si $D_{plot} = D_R$ alors, $H_{plot}$/D $\geq$ 1et de préférence $H_{plot}$/D >2.

Avantageusement, l'étape de formation des plots 1000A1-1000A4 est effectuée de sorte que $d_{cristallite}$ / $d_{plot} \geq$ k3, $d_{plot}$ étant la dimension maximale de la section du plot 1000A1-1000A4 prise dans une direction parallèle au plan dans lequel s'étend la face supérieure 110 substrat 100. Ainsi $d_{plot}$ correspond à la dimension maximale d'une projection du plot dans le plan xy. $d_{cristallite}$ correspond à la dimension de la cristallite mesurée selon la même direction que $d_{plot}$ au moment de la coalescence des cristallites 510A1-510B4.

Selon un exemple 100 $\geq$ k3 $\geq$ 1.1. De préférence, 50 $\geq$ k3 $\geq$ 1.5. De préférence, 5 $\geq$ k3 $\geq$ 2.

Selon un exemple k3 $\geq$ 3, de préférence 100 $\geq$ k3 $\geq$ 3. De préférence, 50 $\geq$ k3 $\geq$ 3. De préférence, 5 $\geq$ k3 $\geq$ 3.

Cette caractéristique permet aux tronçons de fluage de se déformer pour encaisser de manière particulièrement efficace les contraintes mécaniques qui naissent lorsque deux cristallites adjacentes commencent à coalescer. Ainsi, cette caractéristique contribue efficacement à réduire la densité de défauts au sein des vignettes 550A, 550B de nitrure que l'on obtient au final. On veillera à ce que cette caractéristique soit respectée au moins pour les plots de séparation.

## Réduction du risque de fissure au sein de la couche de nitrure et amélioration de la préhension de la couche de nitrure

Comme indiqué précédemment en référence aux figures 1A à 3B, deux phénomènes peuvent apparaître après la formation de la couche de nitrure, et le plus souvent lors du refroidissement qui suit la croissance par épitaxie :

- si les plots 1000 sont trop épais, la couche de nitrure se fissure lors du refroidissement du fait des différences de CTE entre la couche de nitrure et le tronçon cristallin, typiquement à base de silicium. Cet inconvénient est illustré en figure 1B.

- Si les plots 1000 sont trop fins, ils se fracturent lors du refroidissement. La couche de nitrure 550 peut alors se déplacer de manière involontaire et non contrôlée à la surface du substrat 100, rendant sa préhension très délicate. Cet inconvénient est illustré en figures 2A à 3B. Cet inconvénient est d'autant plus préjudiciable lorsque de nombreuses de couches de nitrure, formant chacune une vignette, sont formées sur le substrat. Ce phénomène dépend également de l'épaisseur de la couche de nitrure, typiquement du GaN, que l'on a fait croitre. Dans le cadre du développement de la présente invention, il a en effet été observé qu'en mettant en œuvre le procédé décrit dans le document WO2019122461, si la section des plots est faible, ces derniers peuvent se fracturer involontairement. Il s'ensuit que la couche formée sur les plots se désolidarise du substrat et se déplace éventuellement par rapport à sa position initiale. Comme illustré en figure 2A, lors du refroidissement de la couche de nitrure, une fracturation apparaît sur les plots, en particulier sur les tronçons de fluage des plots. La couche peut alors se détacher entièrement du substrat, comme illustré en figure 2B, de manière parfaitement involontaire.

En référence aux figures 5A à 9B, plusieurs modes de réalisation vont maintenant être décrits en détail pour expliquer comment résoudre ces problèmes.

Ces solutions reposent sur le fait que les plots servant de support à la croissance de la couche présentent entre eux des différences, afin :

- d'une part de contrôler la fracturation de certains plots ou tout au moins de faciliter leur fracturation. Ces plots sont désignés par la suite plots de séparation et sont référencés 1002. Ces plots permettent à la couche de nitrure d'encaisser des contraintes dues aux dilatations thermiques sans pour autant se fissurer. Par ailleurs, ces plots permettent un décollement partiel de la couche de nitrure par rapport au substrat. Ces plots de séparation facilitent évite un détachement involontaire de la couche de nitrure par rapport au substrat.

- d'autre part de s'assurer qu'au moins l'un des plots retienne la couche de nitrure sur le substrat. Ce ou ces plots sont désignés par la suite plots de rétention et sont référencés 1001. Ces plots de rétention permettent ainsi d'empêcher que la couche de nitrure se désoriente par rapport au substrat, voire s'échappe entièrement de celui-ci, ce qui rend les techniques de manipulation de type « pick and place » très délicates à mettre en œuvre.

Chaque ensemble comprend au moins une zone, dite zone de rétention 10R, comprenant les plots de rétention 1001 et comprend au moins une autre zone, dite zone de séparation 10S, comprenant les plots de séparation 1002.

En référence aux figures 5A à 6E, un premier mode de réalisation va être décrit. Dans ce mode de réalisation, la ou les zones de rétention 10R présentent une densité de surface occupée par l'au moins un plot de rétention 1001 sur la vignette (ou sur la couche de nitrure) supérieure à la densité de surface occupée sur la vignette par les plots de rétention 1002 dans les zones de séparation 10S.

Selon un exemple, les rapports $S_{plotR}/D_R$ et $S_{plotS}/D_S$, avec $S_{plotR}/D_R > S_{plotS}/D_S$ et de préférence $S_{plotR}/D_R > 2 * S_{plotS}/D_s$, avec

- $S_{plotR}$ est une surface sommitale de l'au moins un plot de rétention (1001);
- $D_R$ est une distance qui sépare l'au moins un plot de rétention (1001) des plots qui lui sont adjacents;
- $S_{plotS}$ est une surface sommitale des plots de séparation (1002);
- $D_s$ est une distance qui sépare les plots de séparation (1002) des plots qui lui sont adjacents.

De préférence $S_{plotR}/D_R > 1,5 * S_{plotS}/D_s$ et de préférence $S_{plotR}/D_R > 3 * S_{plotS}/D_s$.

Autrement, dit le rapport $R_{Densité} = [(\Sigma S_{plotR} / S_R) / (\Sigma S_{plotS} / S_S)] > 1$, avec : $\Sigma S_{plotR}$ est la somme de l'au moins une surface sommitale de l'au moins un plot de rétention 1001; $S_R$ est la surface de la zone de rétention; $\Sigma S_{plotS}$ est la somme de l'au moins une surface sommitale des plots de séparation 1002; $S_s$ est la surface de la zone de séparation. De préférence, $R_{Densité} = [(\Sigma S_{plotR} / S_R) / (\Sigma S_{plotS} / S_S)] > 2$ et de préférence

$$R_{Densité} = [(\textstyle\sum S_{plotR} / S_R) / (\textstyle\sum S_{plotS} / S_S)] > 3.$$

Pour obtenir cette densité de plots de rétention 1001 supérieure à la densité de plots de séparation 1002, on peut prévoir que :

- le ou les plots de rétention 1001 présentent une section dont la surface est supérieure à celle des plots de séparation 1002. Ce mode de réalisation est illustré en figures 5A à 6E.
- les plots de rétention 1001 sont répartis avec une densité plus forte, c'est dire avec une période plus faible que les plots de séparation 1002. Ce mode de réalisation est illustré en figures 7A à 8C.

Par ailleurs, selon un autre mode de réalisation, c'est deux approches sont combinées. Ainsi, pour obtenir une densité de plots de rétention 1001 supérieure à la densité de plots de séparation 1002, à la fois le ou les plots de rétention 1001 présentent une section supérieure à celle des plots de séparation 1002 et à la fois les plots de rétention 1001 sont répartis avec une densité plus forte, c'est à dire avec une période plus faible que les plots de séparation 1002.

Ces modes de réalisation vont être décrits plus en détail par la suite.

Selon le premier mode de réalisation, le ou les plots de rétention 1002 présente(nt) une section $S_{plotR}$ dont la surface est supérieure à la section $S_{plotS}$ de la section des autres plots. Cette section est prise dans un plan parallèle à la face supérieure 110 du substrat 100. Cette surface correspond par exemple à la surface sommitale des plots. La surface sommitale est la surface du sommet 1010 du plot. Cette surface s'étend dans un plan parallèle à la face supérieure 110 substrat 100. Le sommet est référencé en figure 5A. La surface sommitale est destinée à être au contact de la couche de nitrure. Elle peut être constituée par le tronçon cristallin 300. Si une couche tampon 400 est présente dans le plot, la surface sommitale peut être formée par cette couche tampon 400. Si une couche d'amorce 500 est présente dans le plot, la surface sommitale peut être formée par cette couche d'amorce 500.

De préférence, la surface sommitale $S_{plotR}$ du ou des plots de rétention 1001 est supérieure, de préférence à au moins 2 fois, la surface sommitale $S_{plotS}$ des plots de séparation 1002.

Pour le plot de rétention 1001 la figure 5A fait apparaître la dimension $d_{plotR}$ de la section (par exemple un diamètre du plot 1001) et la figure 6A fait apparaître la surface sommitale $S_{plotR}$.

Pour les plots de séparation 1002 la figure 5A fait apparaître la dimension $d_{plotS}$ de la section et la figure 6A fait apparaître la surface sommitale $S_{plotS}$.

De préférence $d_{plotR}$ est supérieur ou égal à 1,5 fois $d_{plotS}$. De préférence $d_{plotR}$ est supérieur ou égal à 3 fois $d_{plotS}$. Selon un exemple, 100 nm $\leq d_{plotR} \leq$ 500 nm et 50 nm $\leq d_{plotS} \leq$ 200 nm.

De préférence, la surface sommitale $S_{plotR}$ du plot de rétention 1001 est supérieure à 1,5 fois, de préférence à 3 fois, la surface sommitale $S_{plotS}$ du plot de séparation 1002.

Selon un exemple, 10000 nm$^2 \leq S_{plotR} \leq$ 250000 nm$^2$ et 2500 nm$^2 \leq S_{plotS} \leq$ 40000 nm$^2$.

Ainsi, lors du refroidissement qui fait suite à la croissance par épitaxie, les plots de séparation 1002, qui présentent une petite section et sont donc fragiles, se fissurent. Ces fissures 5 sont illustrées en figure 5B. En revanche, le ou les plots de rétention 1001 ne se fissurent pas. En tout état de cause, le plot de rétention 1001 retient la couche 550. Cette dernière ne se déplace pas, et surtout ne s'échappe pas du substrat 100.

Selon un exemple comme celui illustré en figure 5A et 5B, les plots 1001 et 1002 sont tous positionnés à la même distance de leurs voisins. Les plots de rétention 1001 diffèrent des plots de séparation 1002 uniquement par leur section et éventuellement par leurs matériaux. Ainsi, la distance $D_{SR}$ séparant le plot de rétention 1001 du plot de séparation 1002 qui lui est adjacent est égale à la distance $D_s$ séparant les plots de séparation 1002 adjacents.

On peut prévoir plusieurs agencements pour les plots de rétention 1001. Quelques exemples de ces agencements sont illustrés en figures 6A à 6E. Chacune de ces figures illustre de manière schématique une vue du dessus de la couche 550. Les plots 1001, 1002 sont donc représentés en pointillés. Dans chacun de ces exemples, une seule couche de nitrure 550 est illustrée. Pour autant, ces exemples concernent le mode de réalisation dans lequel une unique couche 550 de nitrure est formée sur le substrat 100 ainsi que le mode de réalisation dans lequel de nombreuse couches 550 de nitrure, formant chacune une vignette, sont formées sur le substrat 100.

La figure 6A illustre un exemple dans lequel l'ensemble de plots supportant la couche 550 comprend un unique plot de rétention 1001. Le plot de rétention 1001 est disposé sensiblement au centre de l'ensemble de plots. Les plots de séparation 1002 sont disposés autour du plot de rétention 1001. Cet agencement présente pour avantage de contrôler avec précision la position de la couche 550, puisque, même en cas de rotation de cette couche 550 par rapport au substrat 100, cette couche 550 restera centrée par rapport au(x) plot(s) de rétention 1001. Par ailleurs, le plot de rétention 1001 étant au centre, l'inclinaison de la vignette de procédé est réduite.

La figure 6B illustre un exemple sensiblement identique à celui de la figure 6A, mais dans lequel le plot de rétention 1001 est situé en périphérie de l'ensemble de plots plus précisément dans un coin de cet ensemble de plots. Ainsi, le plot de rétention 1001 retient la couche 550 par l'un des coins de cette dernière, ici le coin en haut à gauche. Cette configuration présente par exemple pour avantage de faciliter le retrait de la vignette, car les on appliquera des efforts de cisaillement (shear stresses) en tirant sur la puce de façon perpendiculaire à la surface.

La figure 6C illustre un exemple sensiblement identique à celui de la figure 6A, mais dans lequel le plot de rétention 1001 est situé en périphérie de l'ensemble de plots plus précisément au milieu d'un côté du pourtour de cet ensemble de plots. Cette configuration présente par exemple pour avantage de faire un compromis entre les deux variantes précédentes.

Les figures 6D et 6E illustrent des exemples comprenant plusieurs plots de rétention 1001, par exemple deux plots de rétention 1001. Dans ces exemples, ces deux plots de rétention 1001 sont adjacents. Ces plots de rétention 1001 sont situés au centre de l'ensemble de plots dans l'exemple illustré en figure 6D. Ces plots de rétention 1001 sont situés dans un coin de l'ensemble de plots dans l'exemple illustré en figure 6E. Ces configurations présentent par exemple pour avantage de minimiser la taille de plot requise pour tenir la vignette, et donc minimiser les contraintes dans les couches supérieures.

Il est préférable d'avoir plusieurs plots de rétention 1001 de section $S_{plotR}$ faibles, par exemple dont la section $S_{plotR}$ est identique à la section $S_{plotS}$ des plots de séparation 1002, plutôt que d'avoir plusieurs plots de rétention 1001 présentant une large section $S_{plotR}$.

Naturellement, dans tous les exemples décrits ci-dessus, il est possible d'ajouter des plots de rétention 1001 additionnels. Par ailleurs, on peut prévoir que certains des plots de rétention 1001 ne soient pas adjacents les uns avec les autres. En effet, il peut être préférable que les plots de rétention 1001, dont la section est supérieure à celle des plots de séparation 1002, ne soient pas adjacents, afin d'éviter la présence d'une zone très contrainte par rapport à son entourage. Ainsi, lorsque l'ensemble de plots comprend plusieurs plots de rétention 1001 qui diffèrent des plots de séparation 1002 par leur section (ou la taille de leur surface sommitale SR), il est possible que chaque plot de rétention 1001 soit entouré uniquement de plots de séparation 1002.

À l'inverse, on notera que prévoir des plots de rétention 1001 adjacents permet de contrôler avec plus de précision les zones où les plots de séparation 1002 se fractureront.

En outre, pour chacun des exemples mentionnés ci-dessus, on peut prévoir que les plots 1001 et 1002 sont tous séparées d'une même distance ( $D_R = D_S$ ). Alternativement, on peut prévoir que ça ne soit pas le cas. On aura alors à la fois $S_{plotR} \neq S_{plots}$ et $D_R \neq D_s$.

En référence aux figures 7A à 7B et 8A à 8C, un deuxième mode de réalisation va être décrit. Dans ce mode de réalisation, on prévoit que la densité de plots varie. Ainsi :

- dans au moins une première zone 10R de l'ensemble de plots, les plots sont espacés d'une distance $D_R$ ;
- dans au moins une deuxième zone 10S de l'ensemble de plots, les plots sont espacés d'une distance $D_s$, avec $D_R < D_s$.

Les distances $D_R$ et $D_S$ sont mesurées dans un plan parallèle à la face supérieure 110 du substrat 100. Les distances $D_R$ et $D_S$ sont illustrées en figures 7A à 8A. Les zones 10R et 10S sont illustrées en figures 8A à 8C. De préférence $D_R$ et $D_s$ sont des distances moyennes qui séparent le plot considéré de tous les plots qui lui sont voisins.

Les plots qui sont espacés des autres plots d'une faible distance, c'est-à-dire de la distance $D_R$, correspondent aux plots de rétention 1001. Chaque ensemble continu de plots de rétention 1001 forme une zone de rétention 10R. Ces plots de rétention 1001 sont en effet organisés, selon un réseau, périodique ou non, présentant une densité importante. Cette densité est en tout état de cause plus importante que pour le reste de l'ensemble de plots. Cette zone de rétention 10R empêche que la couche 550 de nitrure ne se désolidarise du substrat 100. La zone de séparation 10S, présente une densité de plots plus faible, et autorise ou facilite une fissuration de ces plots 1002.

On notera qu'il est possible que les plots de séparation 1002 présentent des distances $D_R$ différentes au sein d'un même ensemble de plots. De même, on peut prévoir que les plots de séparation 1002 présentent des distances $D_s$ différentes au sein d'un même ensemble de plots. En tout état de cause, toutes les distances $D_s$ sont supérieures, d'au moins 1,2 fois et de préférence à 1,5 fois, à toutes les distances $D_R$.

Selon un exemple la distance $D_s$ est supérieure à au moins 1,2 fois, préférence à au moins 1,5 fois, de préférence à au moins 2 fois, et de préférence à au moins 5 fois la distance $D_R$. Les distances $D_R$ et $D_s$ sont mesurées dans un plan parallèle au plan dans lequel s'étend principalement la face supérieure 110 du substrat 100.

Selon un exemple, 50 nm $\leq D_R \leq$ 650 nm et 250 nm $\leq D_S \leq$ 1000 nm.

Selon un exemple, la zone de rétention R10 occupe une surface $S_R$ inférieure à 30% et de préférence inférieure à 20% et de préférence inférieure à 10% à la surface totale $S_V$ occupée par la face supérieure de la couche 550 de nitrure.

Selon un exemple, $S_R \leq 0,3 * S_s$ et de préférence dans lequel $S_R \leq 0,5 * S_s$.

La zone de rétention 10R et la zone de séparation 10Z, qu'elles soient continues ou non, sont toutes les deux définies par des contours. Ces contours sont notés respectivement $C_R$ et $C_S$ en figures 8A à 8C. Le contour $C_R$ entoure tous les plots de rétention 1001. À l'intérieur du contour $C_R$ il n'y a que des plots de rétention 1001. Le contour $C_s$ entoure tous les plots de séparation 1002. A l'intérieur du contour $C_s$ il n'y a que des plots de séparation 1002. Les contours $C_R$ et $C_s$ sont définis de sorte à ce qu'ils soient situés à équidistance d'un plot de rétention 1001 adjacent un plot de séparation 1002.

La surface définie par le contour $C_R$ correspond à la surface de la zone de rétention 10R. Cette surface est notée $S_R$ en figures 8A à 8C.

La surface définie par le contour $C_s$ correspond à la surface de la zone de séparation 10S. Cette surface est notée $S_s$ en figures 8A à 8C. Sur cette figure, la surface totale $S_V$ est également référencée. $S_V = S_R + S_s$. Le contour $C_V$ forme un unique contour fermé alors que les contours $C_R$ et $C_s$ peuvent chacun former plusieurs contours fermés, par exemple si les plots de rétention 1001 sont séparés par des plots de séparation 1002. Par endroits, les contours $C_R$ et $C_s$ peuvent être superposés car une même ligne de séparation définie en partie ces deux contours. De même par endroits, les contours $C_v$ et $C_S$ peuvent être superposés car une partie du contour $C_v$ est définie par le contour $C_s$.

Les plots de l'ensemble 1000A, 1000B sont configurés de sorte que $E_R * (\Sigma S_{plotR}/S_R) > E_S * (\Sigma S_{plotS}/S_S)$, de préférence $E_R * (\Sigma S_{plotR}/S_R) > 1,5 * E_S * (\Sigma S_{plotS}/S_S)$ et de préférence $E_R * (\Sigma S_{plotR}/S_R) > 2 * E_S * (\Sigma S_{plotS}/S_S)$.

- $\Sigma S_{plotR}$ est la somme des surfaces sommitales du ou des plots de rétention 1001, dans les exemples 8A à 8C, il y a plusieurs plots de rétention 1001. $\Sigma S_{plotS}$ est la somme des surfaces sommitales des plots de séparation 1002.

Comme indiqué ci-dessus, $E_R$ est l'énergie nécessaire pour fracturer une unité de surface de l'au moins un plot de rétention 1001. $E_s$ est l'énergie nécessaire pour fracturer une unité de surface des plots de séparation 1002.

Sur les exemples illustrés en figure 8A à 8C, chaque ensemble de plots supportant une couche 550 de nitrure ne comprend qu'une unique zone de rétention 10R. Naturellement, on peut prévoir pour chaque ensemble de plots, et donc pour chaque couche 550 ou chaque vignette 550 de nitrure, une pluralité de zones de rétention 10R. Ces zones de rétention 10R peuvent alors être séparées les unes des autres, par des plots de séparation 1002.

Sur l'exemple illustré en figure 8A, la zone de rétention 10R est située au centre de l'ensemble de plots, et donc au centre de la couche 550 de nitrure.

Sur l'exemple illustré en figure 8B, la zone de rétention 10R est située dans un coin, ici ou à gauche de l'ensemble de plots 1001, 1002.

Sur l'exemple illustré en figure 8C, la zone de rétention 10R est située au milieu d'un côté du pourtour de l'ensemble de plots 1001, 1002.

Sur ces exemples non limitatifs illustrés en figures 7A à 8C, les sections $S_{plotR}$ et $S_{plotS}$ sont identiques. Néanmoins, on peut parfaitement avoir des sections $S_{plotR}$ et $S_{plotS}$ non identiques ainsi que des distances $D_R$ et $D_s$ non identiques, tant que la relation $S_{plotR} / D_s > S_{plotS} / D_s$ est respectée.

En référence aux figures 9A et 9B, un troisième mode de réalisation va être décrit. Dans ce mode de réalisation, on prévoit que la composition, en termes de matériau(x) et d'épaisseur de ce ou ces matériaux diffèrent entre les plots de rétention 1001 et de séparation 1002. Plus précisément l'empilement d'au moins un tronçon formant l'au moins un plot de rétention 1001 et l'empilement des tronçons formant les plots de séparation 1002 sont configurés, en termes de matière et d'épaisseur, de sorte que, pour une section identique de plot, par exemple pour un plot de 1 μm de diamètre, l'énergie $E_R$ nécessaire pour fracturer un plot de rétention 1001 est supérieure à l'énergie $E_s$ nécessaire pour fracturer un plot de séparation 1002.

Selon un exemple, les énergies $E_R$ et $E_s$ se mesurent en appliquant l'une des méthodes bien connues permettant d'identifier l'énergie minimale pour provoquer une fracture ou une fissure dans un matériau, par exemple sous l'effet d'une contrainte en cisaillement ou en torsion.

Selon un mode de réalisation non limitatif :

- le ou les plots de séparation 1002 comprennent le tronçon de fluage 220. Les caractéristiques et avantages techniques de ce tronçon de fluage 220 ont été largement décrits ci-dessus, notamment en référence aux figures 4A à 4F.
- les plots de rétention 1001 ne comprennent pas de tronçon de fluage. Dans ce cas, le tronçon cristallin peut être plus épais que celui du plot de séparation 1002. Il peut s'étendre depuis le substrat 10 jusqu'au sommet du plot 1001 ou jusqu'aux éventuelles couches tampon 400 et/ou d'amorçage 500 comme illustré en figure 9A et 9B. Alternativement, les plots de rétention 1001 comprennent un tronçon de fluage dont la hauteur, prise selon une direction perpendiculaire au plan dans lequel s'étend principalement la face supérieure 110 du substrat 100 est inférieure à la hauteur du tronçon de fluage 220 des plots de séparation 1002. Dans ce cas, le tronçon cristallin peut être plus épais que celui du plot de séparation 1002.

Ainsi, l'empilement est configuré de sorte à ce que les plots de séparation 1002 se fissurent alors beaucoup plus facilement que les plots de rétention 1001.

Selon un exemple, qui correspond à celui illustré en figure 9A et 9B, le tronçon cristallin 300 s'étend depuis la base jusqu'au sommet du plot 1001. On peut par exemple prévoir que le tronçon cristallin 300 forme une continuité de matière avec le substrat 100.

On peut également prévoir que, de manière plus générale, les plots de rétention 1001 et de séparation 1002 sont formés dans des matériaux différents. Les tronçons des plots de rétention 1001 et de séparation 1002 seront alors choisis pour que l'énergie $E_R$ nécessaire pour fracturer une unité de surface d'un plot de rétention 1001 est supérieure à l'énergie $E_s$ nécessaire pour fracturer une même surface d'un plot de séparation 1002. Par exemple, cette unité de surface peut être un plot ou un pilier de $1 μm^2$. De préférence $E_R > 2* E_S$ et de préférence $E_R > 3* E_S$.

Selon un autre exemple lorsque $(\sum S_{plotR}/S_R) > (\sum S_{plots}/S_S)$ ou lorsque $S_{plotR} / D_R > S_{plotS} /D_s$, on prévoit que $E_R = E_s$. Les plots peuvent par exemple être alors tous formés de tronçons présentant des hauteurs et de matériaux identiques, ce qui permet de faciliter le procédé de fabrication.

Dans les exemples décrits ci-dessus en référence aux figures 5A à 9B, les plots de rétention 1001 présentent un seul paramètre qui les différencie des plots de séparation 1002. Ce paramètre étant pris parmi :

- la surface de la section des plots,
- la densité des plots, i.e., la distance les séparant des plots adjacents,
- les matériaux des plots, notamment la présence ou l'absence d'un tronçon de fluage.

Naturellement, on peut prévoir qu'un même ensemble de plots présente au moins deux des paramètres différenciants ci-dessus. Selon un exemple, dans la zone de rétention les plots présentent des diamètres plus importants que dans la zone de séparation et des distances entre plots plus faibles que dans la zone de séparation. Par exemple, l'au moins un plot de rétention diffère des plots de séparation au moins par les deux paramètres suivants au moins : $S_{plotR} \geq 1,2 * S_{plotS}$, et $D_R * 1,2 \leq D_s$.

Selon un exemple, les plots de rétention 1001 se différencient des plots de séparation 1002 par les trois paramètres présentés ci-dessus :

- Les énergies de fracturation par unité de surface $E_R$ et $E_s$;
- Les surfaces sommitales $S_{plotR}$ et $S_{plotS}$
- Les distances entre plots $D_R$ et $D_S$.

Dans chacun de ces modes de réalisation, on prévoit de préférence que le nombre de plots de rétention 1001 est inférieur au nombre de plots de séparation 1002. De préférence, le nombre de plots de rétention 1001 est inférieur à 50% et de préférence inférieur à 30% du nombre total de plots 1001, 1002. Le nombre total de plots est égal à la somme des plots de rétention 1001 et des plots de séparation 1002.

Selon un exemple, la surface occupée par les plots de rétention 1001 est inférieure à 50% et de préférence inférieure à 30% à la surface occupée par l'ensemble des plots 1001, 1002.

Afin de contrôler la rétention de la couche de nitrure tout en réduisant le risque de sa fracturation, on peut également se référer au graphe de la figure 10. Sur ce graphe, l'axe des ordonnées correspond au rapport $E_R$ / $E_S$. L'axe des abscisses correspond au rapport $(\Sigma S_{plotS}/S_S)/(\Sigma S_{plotR})$ /$S_R$) ou au rapport $(\Sigma S_{plotS}/(S_S/S_V))/(\Sigma S_{plotR})$ /$(S_R/S_V)$). Afin de respecter la condition $E_R$ * $(\Sigma S_{plotR}/(S_R/S_V))$ > x1 *$E_S$ * $(\Sigma S_{plotS})$ /$S_S/S_V$), avec x12:1, il faut se placer dans la zone grisée de ce graphe de la figure 10. Ce graphe permet ainsi de sélectionner les paramètres $E_R$, $E_S$, $\Sigma S_{plotS}$, $S_S$, $\Sigma S_{plotR}$, $S_R$.

Au vu de la description qui précède, il apparaît clairement que la présente invention propose une solution particulièrement efficace pour obtenir une unique couche 550 de nitrure ou une pluralité de couche 550 épitaxiées, destinées chacune à former un dispositif tel qu'une micro-LED, une diode ou un transistor.

L'invention n'est pas limitée aux modes de réalisation décrits ci-dessus et s'étend à tous les modes de réalisation couverts par les revendications.

En particulier, sur les figures 5A, 5B, 7A, 7B, la couche de fluage est illustré comme étant discontinue. Ainsi, la couche de fluage ne s'étend pas entre deux plots consécutifs. Naturellement, on peut prévoir que cette couche de fluage s'étende entre deux plots consécutifs, comme cela est le cas sur l'exemple illustré aux figures 4A à 4F.

## Revendications

1. Procédé/ d'obtention d'au moins une couche (550) de nitrure, faite au moins en partie d'un nitrure (N) d'au moins l'un parmi le gallium (Ga), l'indium (In) et l'aluminium (Al), le procédé comprenant les étapes successives suivantes:

    - fournir un empilement comprenant une pluralité de plots (1000A1-1000B4) s'étendant depuis un substrat (100) de l'empilement, les plots (1000A1-1000B4) étant répartis sur le substrat (100) de manière à former au moins un ensemble (1000A, 1000B) de plots (1000A1-1000B4), chaque plot (1000A1-1000B4) comprenant au moins:

        • un tronçon cristallin (300A1, 300B4),
        • un sommet (1010), présentant une surface sommitale, destinée à former pour le plot une couche de germination,

    - faire croître par épitaxie une cristallite (510A1-510B4) depuis le sommet (1010) de certains au moins desdits plots (1000A1-1000B4) de l'ensemble (1000A, 1000B) et poursuivre la croissance épitaxiale des cristallites (510A1-510B4) jusqu'à coalescence des cristallites (510A1-510B4) portées par les plots (1000A1-1000B4) adjacents de l'ensemble (1000A, 1000B), de manière à former sur l'ensemble (1000A, 1000B) de plots (1000A1-1000B4) ladite couche (550) de nitrure,

la pluralité de plots (1000A1-1000B4) de l'au moins un ensemble comprenant au moins un plot (1001), dit de rétention, et plusieurs autres plots (1002), dits de séparation, les plots de séparation (1002) comprenant un tronçon de fluage (220), formé en un matériau amorphe présentant une température de transition vitreuse Transition vitreuse, le tronçon cristallin (300) surmontant le tronçon de fluage (220), l'au moins un plot de rétention (1001) diffère des plots de séparation (1002) par au moins un paramètre pris parmi :

    - une surface sommitale $S_{plotR}$ de l'au moins un plot de rétention (1001), avec $S_{plotR} \geq 1,2 * S_{plots}$, $S_{plotS}$ étant une surface sommitale des plots de séparation (1002),
    - les matériaux constituant l'au moins un plot de rétention (1001) et les plots de séparation (1002), les plots de rétention (1001) :

        • ne présentant pas de tronçon de fluage ou
        • présentant un tronçon de fluage moins épais que le tronçon de fluage (220) des plots de séparation (1002), ou
        • présentant un tronçon de fluage présentant une température de transition vitreuse $T_{transition\ vitreuse300}$ supérieure à la température de transition vitreuse Transition vitreuse du tronçon de fluage des plots de séparation (1002),

    - une distance $D_R$, $D_R$ étant la distance séparant l'au moins un plot de rétention (1001) d'autres plots de rétention (1001) qui lui sont adjacents et qui appartiennent à l'ensemble (1000A, 1000B) de plots, avec $D_R * 1,2 \leq D_S$, $D_S$ étant la distance séparant les plots de séparation (1002) adjacents appartenant à l'ensemble (1000A, 1000B) de plots.

**2.** Procédé selon la revendication précédente, dans lequel la pluralité de plots de l'ensemble (1000A, 1000B) est configurée de sorte que $E_R * (\sum S_{plotR}/(S_R/S_V)) > x1 * E_S * (\sum S_{plotS}/S_S/S_V))$, avec $x1 \geq 1$ et de préférence $x1 \geq 1,5$ et de préférence $x1 \geq 2$, avec

- $\sum S_{plotR}$ est la somme des surfaces sommitales de l'au moins un plot de rétention (1001) et $\sum S_{plotS}$ est la somme des surfaces sommitales des plots de séparation (1002);
- $E_R$ est l'énergie nécessaire pour fracturer une unité de surface de l'au moins un plot de rétention (1001), et $E_S$ est l'énergie nécessaire pour fracturer une unité de surface des plots de séparation (1002),
- $S_R$ est une surface d'une zone (10R) du substrat (100) présentant un contour $C_R$ entourant l'au moins un plot de rétention (1001) de l'ensemble; $S_s$ est une surface d'une zone (10S) du substrat (100) présentant un contour $C_s$ entourant les plots de séparation (1002) de l'ensemble (1000A, 1000B), la somme de $S_S$ et $S_R$ étant égale à la surface $S_V$ d'une zone du substrat (100) présentant un contour $C_V$ entourant les plots de rétention (1001) et les plots de séparation (1002) de l'ensemble (1000A, 1000B), le contour $C_V$ formant un unique contour fermé.

**3.** Procédé selon l'une quelconque des revendications précédentes, dans lequel l'au moins un plot de rétention (1001) et les plots de séparation (1002) sont configurés de sorte qu'une fois la couche (550) de nitrure formée l'au moins un plot de rétention (1001) retient la couche (550) de nitrure, et de préférence l'au moins un plot de rétention (1001) retient la couche (550) de nitrure après un refroidissement de la couche (550) de nitrure à une température au moins deux fois inférieure à une température $T_{épitaxie}$ à laquelle est effectuée la croissance épitaxiale.

**4.** Procédé selon l'une quelconque des revendications précédentes, dans lequel l'au moins un plot de rétention (1001) et les plots de séparation (1002) sont configurés de sorte qu'une fois la couche (550) de nitrure formée et après un refroidissement de la couche (550) de nitrure à une température au moins deux fois inférieure à une température $T_{épitaxie}$ à laquelle est effectuée la croissance épitaxiale, au moins certains des plots de séparation (1002) sont fracturés.

**5.** Procédé selon l'une quelconque des revendications précédentes, dans lequel les plots (1000A1-1000B4) sont répartis sur le substrat (100) de manière à former une pluralité d'ensembles (1000A, 1000B) de plots (1000A1-1000B4) et l'étape de croissance par épitaxie est interrompue avant que des cristallites (510A1-510B4) appartenant à deux ensembles (1000A, 1000B) distincts n'entrent en coalescence, de sorte à ce que la couche formée sur chaque ensemble (1000A, 1000B) forme une vignette, les vignettes étant distantes les unes des autres.

**6.** Procédé selon l'une quelconque des revendications précédentes, dans lequel $E_R > E_s$ et de préférence $E_R > 2 * E_s$, $E_R$ étant l'énergie nécessaire pour fracturer une unité de surface de l'au moins un plot de rétention (1001), et $E_s$ étant l'énergie nécessaire pour fracturer une unité de surface des plots de séparation (1002).

**7.** Procédé selon l'une quelconque des revendications précédentes, dans lequel la surface sommitale $S_{plotR}$ de l'au moins un plot de rétention (1001) est supérieure à au moins 1,2 fois et de préférence à au moins 1,5 fois, de préférence à au moins 3 fois la surface sommitale $S_{plotS}$ des plot de séparation (1002).

**8.** Procédé selon l'une quelconque des revendications précédentes, dans lequel, 100 nm $\leq d_{plotR} \leq 500$ nm et 50 nm $\leq d_{plotS} \leq 200$ nm, $d_{plotR}$ et $d_{plotS}$ étant respectivement la dimension maximale de la section de l'au moins un plot de rétention (1001) et la dimension maximale de la section de l'au moins un plot (1002) de séparation.

**9.** Procédé selon l'une quelconque des revendications précédentes, dans lequel $D_R$ est la distance séparant l'au moins un plot de rétention (1001) d'autres plots de rétention (1001) qui lui sont adjacents et qui appartiennent à l'ensemble (1000A, 1000B) de plots, $D_s$ est la distance séparant les plots de séparation (1002) adjacents appartenant à l'ensemble (1000A, 1000B) de plots, et avec $D_R * 1,5 \leq D_s$, de préférence $D_R * 2 \leq D_s$ et de préférence $D_R * 5 \leq D_s$.

**10.** Procédé selon l'une quelconque des revendications précédentes, dans lequel pour chaque ensemble, $S_R$ est une surface d'une zone du substrat (100) présentant un contour $C_R$ entourant l'au moins un plot de rétention (1001), $S_s$ est une surface d'une zone (10S) du substrat (100) présentant un contour $C_s$ entourant les plots de séparation (1002), la somme de $S_s$ et $S_R$ étant égale à la surface $S_V$ d'une zone du substrat (100) présentant un contour $C_V$ entourant les plots de rétention (1001) et les plots de séparation (1002) de l'ensemble (1000A, 1000B), le contour $C_V$ formant un unique contour fermé, avec $S_R$ inférieure à 30% et de préférence inférieure à 10% à $S_V$, et de préférence dans lequel $S_R \leq 0,3 * S_S$ et de préférence dans lequel $S_R \leq 0,5 * S_S$.

**11.** Procédé selon l'une quelconque des revendications précédentes, dans lequel le nombre de plots de rétention (1001) est inférieur de 50% et de préférence inférieur de 30% au nombre total de plots (1001, 1002) de l'ensemble (1000A, 1000B).

**12.** Procédé selon l'une quelconque des revendications précédentes, dans lequel, l'au moins un ensemble (1000A, 1000B) comprend plusieurs plots de rétention (1001), tous les plots de rétention (1001) d'un ensemble (1000A, 1000B) étant situés dans une unique zone (10R) du substrat (100), continue.

**13.** Procédé selon l'une quelconque des revendications précédentes, dans lequel, les plots de rétention (1001) et les plots de séparation (1002) sont configurés de sorte à vérifier au moins deux et de préférence au moins trois des relations suivantes :

- $E_R \neq E_S$, $E_R$ étant l'énergie nécessaire pour fracturer une unité de surface de l'au moins un plot de rétention (1001), et $E_s$ étant l'énergie nécessaire pour fracturer une unité de surface des plots de séparation (1002).
- $D_R \neq D_s$,
- $S_{plotR} \neq S_{plotS}$.

**14.** Procédé selon l'une quelconque des revendications précédentes, dans lequel, la croissance épitaxiale est effectuée à une température $T_{épitaxie}$, telle que : $T_{épitaxie} \geq k1 \times$ Transition vitreuse, avec $k1 \geq 0,8$ et de préférence dans lequel $k1 \geq 1$, et de préférence $k1 \geq 1,5$.

**15.** Procédé selon l'une quelconque des revendications précédentes dans lequel le tronçon de fluage (220) est fait d'un matériau pris parmi :

- un oxyde de silicium SixOy, x et y étant des entiers, et de préférence la couche de fluage est en $SiO_2$,
- un verre,
- un verre en borosilicate,
- un verre en borophosphosilicate (BPSG).

FIG. 1A

FIG. 1B

FIG. 2A

FIG. 2B

300
550
5
210
100
5

g = 0002

500nm

FIG. 3A

500

Vignette (chip)

Pillars

1000

100

2μm

FIG. 3B

FIG. 4A

FIG. 4B

FIG. 4C

FIG. 4D

FIG. 4E

FIG. 4F

EP 4 020 525 A1

$D_{SR}$  $D_S$

$d_{plotR}$  $d_{plotS}$

1010
400
300
220
1010
100

550
400
300
220
100

1001  1002

FIG. 5A

5

400
300
220
100

550
400
300
220
100

1001  1002

FIG. 5B

FIG. 6A

FIG. 6B

FIG. 6C

FIG. 6D

FIG. 6E

550
400
300
220
100

$D_R$   $D_S$

1001   1002

FIG. 7A

550
400
300
220
100

1001   1002

FIG. 7B

FIG. 8A

FIG. 8B

FIG. 8C

400

300

100

510

400

300

220

100

1001          1002

FIG. 9A

110                    5

400

300

100

510

400

300

220

100

1001          1002

FIG. 9B

FIG. 10

Europäisches
Patentamt
European
Patent Office
Office européen
des brevets

**RAPPORT DE RECHERCHE EUROPEENNE**

Numéro de la demande

**EP 21 21 6193**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y,D | WO 2019/122461 A1 (COMMISSARIAT ENERGIE ATOMIQUE [FR]; CENTRE NAT RECH SCIENT [FR]) 27 juin 2019 (2019-06-27) | 1-6, 9-12,14, 15 | INV. H01L21/02 |
| A | * page 11 – page 19; figures 1A-1E * | 7,8,13 | |
| Y | US 2013/020594 A1 (AHN HYUNG-SOO [KR] ET AL) 24 janvier 2013 (2013-01-24) * alinéas [0052] – [0054]; figures 2A-2B * | 1-6, 9-12,14, 15 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 21 avril 2022 | Dehestru, Bastien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................................
& : membre de la même famille, document correspondant

EPO FORM 1503 03.82 (P04C02)

**EP 4 020 525 A1**

## ANNEXE AU RAPPORT DE RECHERCHE EUROPEENNE
## RELATIF A LA DEMANDE DE BREVET EUROPEEN NO.

EP 21 21 6193

21-04-2022

| Document brevet cité au rapport de recherche | Date de publication | Membre(s) de la famille de brevet(s) | | Date de publication |
|---|---|---|---|---|
| WO 2019122461 A1 | 27-06-2019 | CN | 111742085 A | 02-10-2020 |
| | | EP | 3728703 A1 | 28-10-2020 |
| | | FR | 3075833 A1 | 28-06-2019 |
| | | US | 2021164126 A1 | 03-06-2021 |
| | | WO | 2019122461 A1 | 27-06-2019 |
| US 2013020594 A1 | 24-01-2013 | CN | 103038901 A | 10-04-2013 |
| | | EP | 2555256 A2 | 06-02-2013 |
| | | JP | 5512877 B2 | 04-06-2014 |
| | | JP | 2013524502 A | 17-06-2013 |
| | | US | 2013020594 A1 | 24-01-2013 |
| | | WO | 2011122882 A2 | 06-10-2011 |

EPO FORM P0460

**RÉFÉRENCES CITÉES DANS LA DESCRIPTION**

**Documents brevets cités dans la description**

- WO 2019122461 A